(19) **Europäisches Patentamt**

**European Patent Office**

**Office européen des brevets**

(11) **EP 1 560 331 A1**

(12) **EUROPEAN PATENT APPLICATION**
published in accordance with Art. 158(3) EPC

(43) Date of publication:
**03.08.2005 Bulletin 2005/31**

(51) Int Cl.⁷: **H03G 3/10**

(21) Application number: **04702042.5**

(22) Date of filing: **14.01.2004**

(86) International application number:
**PCT/JP2004/000181**

(87) International publication number:
**WO 2004/064251 (29.07.2004 Gazette 2004/31)**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **14.01.2003 JP 2003006171**

(71) Applicant: **MATSUSHITA ELECTRIC INDUSTRIAL CO., LTD.**
**Kadoma-shi, Osaka 571-8501 (JP)**

(72) Inventor: **UDAGAWA, Masaharu**
**. (JP)**

(74) Representative: **Grünecker, Kinkeldey, Stockmair & Schwanhäusser Anwaltssozietät**
**Maximilianstrasse 58**
**80538 München (DE)**

(54) **VARIABLE GAIN AMPLIFIER CIRCUIT AND RADIO MACHINE**

(57) A variable gain amplifier circuit is provided so that an electric current decreases when a voltage gain is lowered and that the amplifier circuit is substantially free of a deterioration in distortion characteristics.

The bases of bipolar transistors Q1, Q3 and Q5 and the bases of bipolar transistors Q2, Q4 and Q6 are connected in common with each other, these bipolar transistors forming a plurality of common-emitter amplifier circuits, and switches SW2, SW1 and SW0 are connected to the respective sides of the bipolar transistors. The emitter sides are held at a ground potential gnd by switching the switches SW2, SW1 and SW0 so that the voltage gain is controlled by selecting the common-emitter amplifier circuits different in voltage gain. A collector current 10 and an emitter degeneration resistance Re between the common-emitter amplifier circuits are so arranged as to have different values. The ratio of the collector current 10 is set inversely proportional to the ratio of the emitter degeneration resistance Re, whereby the collector current 10 decreases when the voltage gain is lowered and a deterioration in distortion characteristics is substantially obviated.

FIG. 1

**Description**

<Technical Field>

The present invention relates to a variable gain amplifier circuit and a radio communication apparatus fitted with the same.

<Background Art>

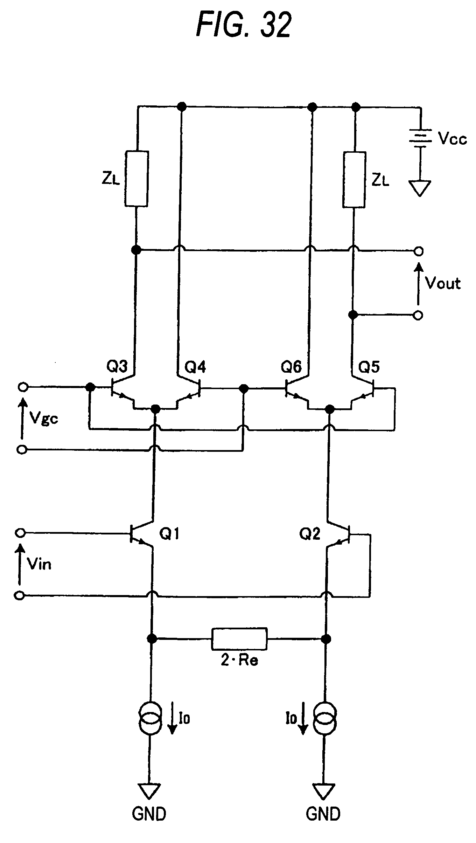

Conventional variable gain amplifier circuits are shown in Figs. 32 - 34 by way of example. The conventional variable gain amplifier circuit shown in Fig. 32 as a first example is formed with a pair of common-emitter amplifier circuits having bipolar transistors Q1 and Q2, and differential pairs of bipolar transistors Q3 and Q4 and bipolar transistors Q5 and Q6. With this arrangement, an input signal Vin is fed into the bases of the bipolar transistors Q1 and Q2 and the output current of the common-emitter amplifier circuit branches out in accordance with a gain control voltage Vgc fed into the bases of the bipolar transistors Q3 - Q6 forming the differential pair. The voltage gain Av2 of the variable gain amplifier circuit is expressed by an equation 1 a below and controlled by the gain control voltage Vgc under the assumption of ideal bipolar transistors.

$$Av2 = gm2 \cdot ZL \cdot exp(Vgc/Vt)/(exp(Vgc/Vt) + 1) \qquad (1a)$$

provided gm2 is expressed by an equation 1 b below:

$$gm2 = 1/(Vt/IO) + (Re)) \qquad (1b)$$

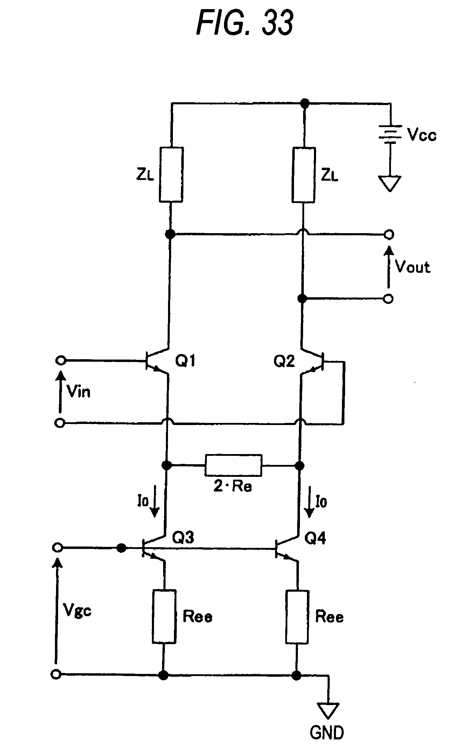

where Vt is thermal voltage (about 26 mV at room temperature (see Non-Patent Document 1, for example).
The conventional variable gain amplifier circuit shown in Fig. 33 as a second example employs bipolar transistors Q3 and Q4 as constant current sources and controls the gain of a set of common-emitter amplifier circuits having bipolar transistors Q1 and Q2 by varying a collector current IO in accordance with the gain control voltage Vgc. The voltage gain Av3 of the variable gain amplifier circuit is expressed by an equation 2a below and controlled by the gain control voltage Vgc under the assumption of ideal bipolar transistors.

$$Av3 = gm3 \cdot ZL \qquad (2a)$$

provided gm3 and Vgc are expressed by equations 2b and 2c below:

$$gm3 = 1/(Vt/IO) + (Re) \qquad (2b)$$

$$Re \cdot IO + Vt \cdot log(IO/Is) = Vgc \qquad (2c)$$

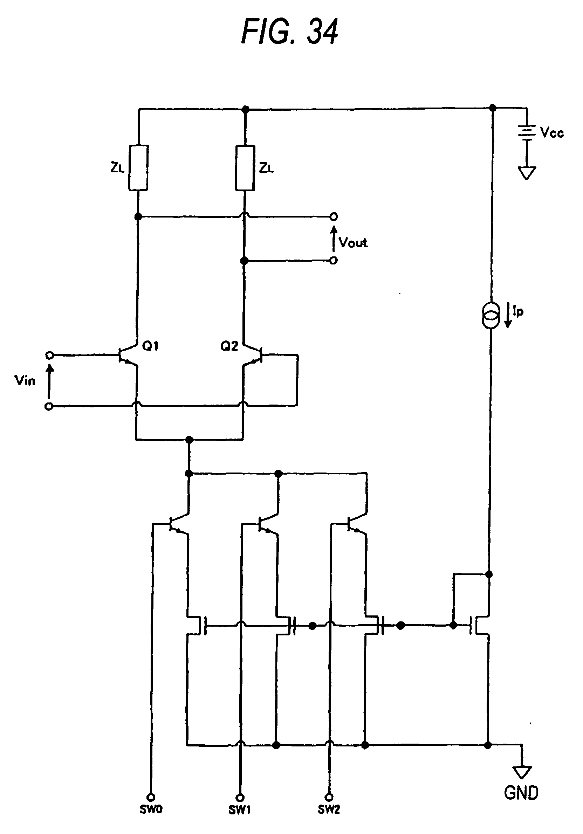

In this case, Is denotes the saturation currents of the bipolar transistors Q3 and Q4, and log () a natural logarithmic function (see Patent Document 1, for example).
Further, the conventional variable gain amplifier circuit shown in Fig. 34 as a third example is similar in configuration to the conventional example 2 shown in Fig. 33, wherein though a voltage gain Av4 is controlled by varying the collector current IO likewise, the way to vary the collector current IO differs. The voltage gain Av4 of the variable gain amplifier circuit is expressed by an equation 3a below:

$$Av4 = gm4 \cdot ZL \qquad (3a)$$

provided gm4 is expressed by an equation 3b below, whereby the voltage gain Av4 is made controllable by the collector current 10 (see Patent Document 2, for example).

$$gm4 = 1/((Vt/IO) + (Re)) \tag{3b}$$

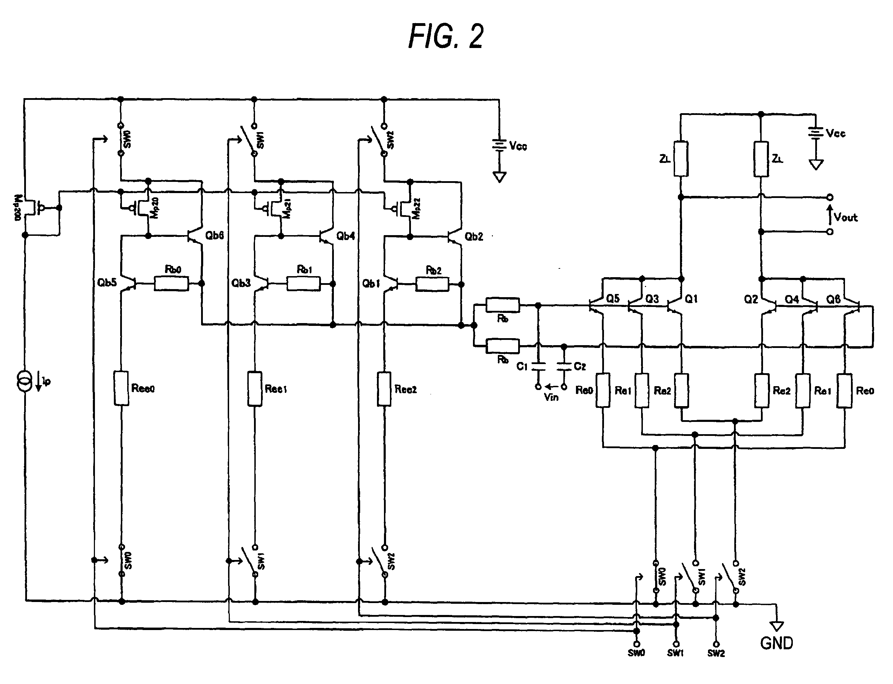

(Non-Patent Document 1) Robert G Meyer, and William D. Mack 'A DC to 1-GHz Differential Monolithic Variable-Gain Amplifier,' IEEE Journal of Solid-State Circuits, Nov., 1991, Vol. 26, No. 11, pp 1673-1680 (Fig. 2)
(Patent Document 1) JP-T-10-503917 (Fig. 1)
(Patent Document 2) JP-UM-A-1-179620 (Fig. 1)
However, the conventional variable gain amplifier circuit shown in Fig. 32 as the first example always consumes a constant collector current IO irrespective of the gain control voltage Vgc as seen from Eq. 1 a and Eq. 1 b. On the other hand, the suppression ratio IM3 of the three-dimensional intermodulation distortion as one of the distortion characteristics to the desired wave is expressed by an equation 4 below under the assumption of ideal bipolar transistors.

$$IM3 = (3/4) \cdot |(Vt/(IO^3) \cdot (2 \cdot Re - (Vt/IO)))/$$

$$((Re + (Vt/10))^4)| \cdot (Vin^2) \tag{4}$$

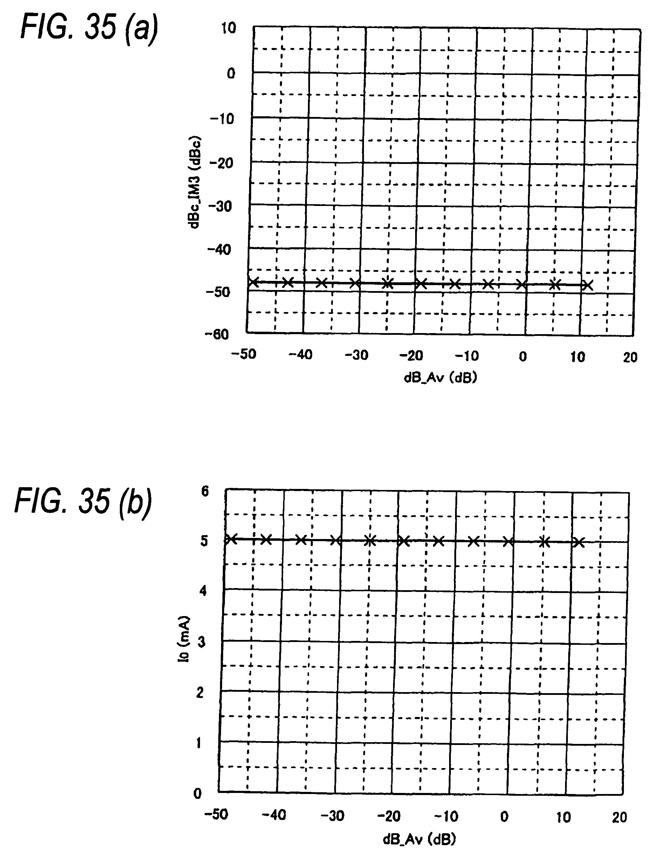

In this case, $\|$ refers to an absolute value. In addition, approximation based on the approach that midpoint ground of a differential amplifier circuit is valid, has been used for the sake of brevity. As a signal grows larger, the signal deviates from the approximation, whereupon the IM3 deteriorates further.
As seen from Eq. 4, the distortion characteristics are controlled by the collector current IO and a comparatively large collector current is required to maintain the suppression ratio IM3 in good condition. Now, Figs. 35(a) and (b) show the relation between the suppression ratio IM3 and the collector current IO with respect to a voltage gain Av when the voltage gain Av is controlled by varying the gain control voltage Vgc calculated from the Eqs. 1 a and 1 b and Eq. 4 (the voltage gain being Av2 in the equation). In Figs. 35(a) and (b), the suppression ratio IM3 and the voltage gain Av are not antilogarithms but those expressed in dBc or dB as a unit. Therefore, the problem is that because the conventional variable gain amplifier circuit as the first example always consumes a relatively large current irrespective of the voltage gain, the current consumed thereby never decreases even though the voltage gain is lowered.
On the contrary, the conventional variable gain amplifier circuits respectively shown in Fig. 33 and Fig. 34 as the second and third examples reveal that as seen from Eqs. 2a and 2b and Eqs. 3a and 3b, the collector current decreases when the voltage gain is lowered. On the other hand, the suppression ratio IM3 becomes equal to what is shown in Eq. 4 and is expressed by an equation 5 below under the assumption of ideal bipolar transistors.

$$IM3 = (3/4) \cdot |(Vt/(IO^3) \cdot (2 \cdot Re - (Vt/IO)))/$$

$$((Re + (Vt/10))^4)| \cdot (Vin^2) \tag{5}$$

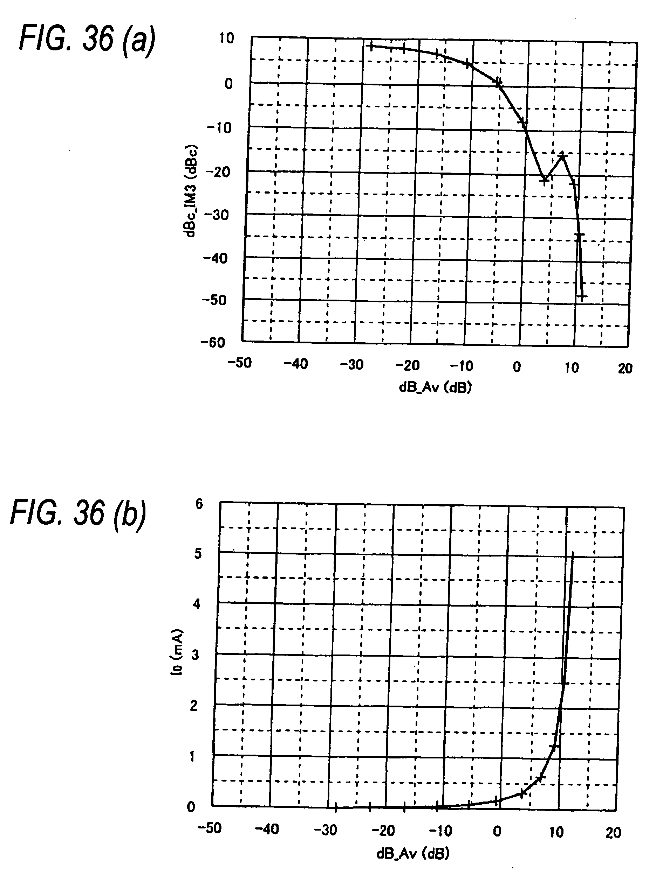

Approximation for establishing a way of approaching the midpoint grounding of a differential amplifier circuit has been used also for the sake of brevity. As a signal grows larger, it deviates from the approximation, whereupon the IM3 deteriorates further.
What is seen from Eq. 5 is that in the conventional variable gain amplifier circuits as the second and third examples, there develops a problem arising from the deterioration of the suppression ratio IM3 except for a singular point where $2 \cdot Re = (Vt/IO)$ as the collector current IO decreases when the voltage gain Av (the voltage gain being Av3 or Av4 in the equation) is lowered. Figs. 36(a) and (b) show the relation between the suppression ratio IM3 and the collector current IO with respect to the voltage gain Av when the voltage gain Av is controlled by varying the gain control voltage Vgc or the collector current IO calculated from the Eqs. 2a and 2b or 3a and 3b and Eq. 5.
An object of the invention made to solve the foregoing problems is to provide an excellent variable gain amplifier circuit which causes an electric current to decrease when a voltage gain is lowered and is substantially free of a deterioration in distortion characteristics represented by the suppression ratio, and a radio communication apparatus using the same.

<Disclosure of the Invention>

A variable gain amplifier circuit according to the invention is provided with a plurality of common-emitter amplifier circuits which are different in voltage gain and employ bipolar transistors and switch means for selecting the plurality of amplifier circuits, wherein: the bases of the bipolar transistors are connected in common with each other; and the switch means are connected to the respective emitter sides of the bipolar transistors.

With the arrangement above, the current decreases when the voltage gain is lowered and a deterioration in distortion characteristics represented by the suppression ratio can substantially be obviated.

A variable gain amplifier circuit according to the invention is provided with a plurality of amplifier circuits which are different in voltage gain and employ bipolar transistors and formed with an common-emitter and common-base cascade connection and switch means for selecting the plurality of amplifier circuits, wherein: the bases of the common-emitter bipolar transistors are connected in common with each other; and the switch means are connected to the respective emitter sides of the bipolar transistors.

With the arrangement above, the current decreases when the voltage gain is lowered and it is possible to achieve the effect of enlarging the dynamic range of gain control in addition to the effect of substantially obviating a deterioration in distortion characteristics represented by the suppression ratio.

In any one of the variable gain amplifier circuits above, a collector current ratio between the plurality of amplifier circuits is inversely proportional to an emitter degeneration resistance ratio.

With the arrangement above, it is possible to decrease the current when the voltage gain is lowered and to substantially obviate a deterioration in distortion characteristics by making the collector current ratio inversely proportional to the emitter degeneration resistance ratio, that is, making the collector current ratio equal to the ratio of the reciprocal of the emitter degeneration resistance whereby to selectively switch the plurality of amplifier circuits different in voltage gain with the switch means. Moreover, resistance to noise can be reinforced by adding emitter degeneration resistors in phase as emitter degeneration resistors.

In any one of the variable gain amplifier circuits above, an emitter area ratio between common-emitter transistors in the plurality of amplifier circuits is inversely proportional to the emitter degeneration resistance ratio.

With the arrangement above, it is possible to decrease the current when the voltage gain is lowered and to substantially obviate a deterioration in distortion characteristics by making the emitter area ratio inversely proportional to the emitter degeneration resistance ratio, that is, making the emitter area ratio equal to the ratio of the reciprocal of the emitter degeneration resistance whereby to selectively switch the plurality of amplifier circuits different in voltage gain with the switch means.

In any one of the variable gain amplifier circuits above, the emitter area ratio between the common-emitter transistors in the plurality of amplifier circuits is in powers of 2.

With the arrangement above, the area ratio is readily attainable with accuracy when the physical configuration of the element is taken into consideration. When a mask layout is carried out with the variable gain amplifier circuit as IC or LSI, for example, two of the bipolar transistors having the same configuration are connected in parallel, whereby the emitter area can be doubled with accuracy.

In any one of the variable gain amplifier circuits above, the emitter degeneration resistance ratio between the plurality of amplifier circuits is in powers of 2.

With the arrangement above, the emitter degeneration resistance ratio is readily attainable with accuracy when the physical configuration of the element is taken into consideration. When a mask layout is carried out with the variable gain amplifier circuit as IC or LSI, for example, two of the resistance elements having the same configuration are connected in parallel, whereby the resistance value can be halved with accuracy.

A variable gain amplifier circuit according to the invention is provided with a plurality of common-source amplifier circuits which are different in voltage gain and employ field effect transistors and switch means for selecting the plurality of amplifier circuits, wherein: the gates of the field effect transistors are connected in common with each other; and the switch means are connected to the respective source sides of the field effect transistors.

With the arrangement above, the current decreases when the voltage gain is lowered and a deterioration in distortion characteristics represented by the suppression ratio can substantially be obviated. Moreover, the circuit can be operated with a lower supply voltage by employing the field effect transistors.

A variable gain amplifier circuit according to the invention is provided with a plurality of amplifier circuits which are different in voltage gain and employ field effect transistors and formed with a common-source and common-gate cascade connection and switch means for selecting the plurality of amplifier circuits, wherein: the gates of the common-source field effect transistors are connected in common with each other; and the switch means are connected to the respective source sides of the field effect transistors.

With the arrangement above, the current decreases when the voltage gain is lowered and it is possible to achieve the effect of enlarging the dynamic range of gain control in addition to the effect of substantially obviating a deterioration in distortion characteristics represented by the suppression ratio. Moreover, the circuit can be operated with a lower supply voltage by employing the field effect transistors.

In any one of the variable gain amplifier circuits above, a drain current ratio between the plurality of amplifier circuits is inversely proportional to a source degeneration resistance ratio.

With the arrangement above, it is possible to decrease the current when the voltage gain is lowered and to substantially obviate a deterioration in distortion characteristics by making the drain current ratio inversely proportional to the source degeneration resistance ratio, that is, making the drain current ratio equal to the ratio of the reciprocal of the source degeneration resistance whereby to selectively switch the plurality of amplifier circuits different in voltage gain with the switch means. Moreover, resistance to noise can be reinforced by adding source degeneration resistors in phase as source degeneration resistors.

In any one of the variable gain amplifier circuits above, a gate width ratio between common-source transistors in the plurality of amplifier circuits is inversely proportional to the source degeneration resistance ratio.

With the arrangement above, it is possible to decrease the current when the voltage gain is lowered and to substantially obviate a deterioration in distortion characteristics by making the gate width ratio inversely proportional to the source degeneration resistance ratio, that is, making the gate width ratio equal to the ratio of the reciprocal of the source degeneration resistance whereby to selectively switch the plurality of amplifier circuits different in voltage gain with the switch means.

In any one of the variable gain amplifier circuits above, the gate width ratio between the common-source transistors in the plurality of amplifier circuits is in powers of 2.

With the arrangement above, the gate width ratio is readily attainable with accuracy when the physical configuration of the element is taken into consideration. When a mask layout is carried out with the variable gain amplifier circuit as IC or LSI, for example, two of the MOS transistors having the same configuration are connected in parallel, whereby the gate width can be doubled with accuracy.

In any one of the variable gain amplifier circuits above, the source degeneration resistance ratio between the plurality of amplifier circuits is in powers of 2.

With the arrangement above, the source degeneration resistance ratio is readily attainable with accuracy when the physical configuration of the element is taken into consideration. When a mask layout is carried out with the variable gain amplifier circuit as IC or LSI, for example, two of the resistance elements having the same configuration are connected in parallel, whereby the resistance value can be halved with accuracy.

In any one of the variable gain amplifier circuits above, the switch means is a current source.

With the arrangement above, as the plurality of amplifier circuits can be selected so as to control the voltage gain by setting the collector current or the drain current in each of the plurality of amplifier circuits with the current source, the current decreases when the voltage gain is lowered and a deterioration in distortion characteristics can substantially be obviated.

In any of the variable gain amplifier circuits above, the switch means is a transistor.

With the arrangement above, when the plurality of amplifier circuits different in voltage gain are selected by the transistor switch means, switching these amplifier circuits is made such that the emitter or source side of an amplifier circuit to be selected is held at the ground potential, whereas the emitter or source side of what is not to be selected is opened, so that the voltage gain becomes controllable. Thus, the current decreases when the voltage gain is lowered and a deterioration in distortion characteristics can substantially be obviated. The on-resistance of the transistor is minimized or the on-resistance ratio is set equal to the emitter degeneration resistance ratio or the source degeneration resistance ratio, whereby the voltage gain is made controllable with accuracy. Moreover, a circuit can easily be integrated into LSI by using transistors.

In any one of the variable gain amplifier circuits above, the switch means is an inverter.

With the arrangement above, when the plurality of amplifier circuits different in voltage gain are selected by the inverter switch means, switching these amplifier circuits is made such that the emitter or source side of an amplifier circuit not to be selected is held at a positive power supply voltage, so that the voltage gain becomes controllable. Thus, the current decreases when the voltage gain is lowered and a deterioration in distortion characteristics can substantially be obviated. Moreover, a circuit can easily be integrated into LSI by using inverter.

Any one of the variable gain amplifier circuits above has bias circuits respectively corresponding to the plurality of amplifier circuits.

With the arrangement above, the collector or drain current ratio can accurately be realized by providing the bias circuits when the voltage gain is controlled.

Any one of the variable gain amplifier circuits above has a decoder as decoding means for receiving and decoding a digital signal and selecting any one of the plurality of amplifier circuits by its output corresponding to the digital signal received.

With the arrangement above, the voltage gain of the variable gain amplifier circuit is made controllable by using the decoder in every unit of predetermined quantities, depending on the value of an input signal to the decoder.

Any one of the variable gain amplifier circuits above has a decoder as decoding means for receiving and decoding a digital signal and selecting any combination of amplifier circuits by its output corresponding to the digital signal received.

With the arrangement above, the voltage gain of the variable gain amplifier circuit is made controllable by using the decoder in each smaller predetermined unit over a predetermined range depending on the input signal value to the decoder.

Any one of the variable gain amplifier circuits above has decoding means for receiving and decoding a digital signal, including a first decoder for selecting one of the plurality of amplifier circuits by its output corresponding to the digital signal received and a second decoder for selecting any combination of amplifier circuits by its output corresponding to the digital signal received.

With the arrangement above, the variable gain amplifier circuit using the first decoder and the variable gain amplifier circuit using the second decoder are connected in series, for example, whereby the voltage gains of the variable gain amplifier circuits become controllable in each smaller predetermined unit over a predetermined range depending on the input signal value to the decoder.

Further, a radio communication apparatus having any one of the variable gain amplifier circuits above as an amplifier circuit is provided by the invention.

With the arrangement above, it is possible to decrease the current when the voltage gain is lowered in the radio circuits and to realize a radio communication apparatus substantially free of a deterioration in distortion characteristics.

<Brief Description of the Drawings>

Fig. 1 is a circuit diagram showing a variable gain amplifier circuit configuration according to a first embodiment of the invention.

Fig. 2 is a circuit diagram showing a variable gain amplifier circuit configuration including bias circuits as an application example of the first embodiment of the invention.

Fig. 3 is a graph showing the relation between a suppression ratio IM3 and a collector current IO with respect to the voltage gain Av of the variable gain amplifier circuit according to the first embodiment of the invention.

Fig. 4 is a circuit diagram showing a variable gain amplifier circuit configuration as a modified example of the first embodiment of the invention.

Fig. 5 is a circuit diagram showing a variable gain amplifier circuit configuration according to a second embodiment of the invention.

Fig. 6 is a circuit diagram showing a variable gain amplifier circuit configuration according to a third embodiment of the invention.

Fig. 7 is a circuit diagram showing a variable gain amplifier circuit configuration as a modified example of the third embodiment of the invention.

Fig. 8 is a circuit diagram showing a variable gain amplifier circuit configuration according to a fourth embodiment of the invention.

Fig. 9 is a circuit diagram showing a variable gain amplifier circuit configuration according to the fourth embodiment of the invention.

Fig. 10 is a circuit diagram showing a variable gain amplifier circuit configuration according to a fifth embodiment of the invention.

Fig. 11 is a circuit diagram showing a variable gain amplifier circuit configuration as a modified example of the fifth embodiment of the invention.

Fig. 12 is a circuit diagram showing a variable gain amplifier circuit configuration as a modified example of the fifth embodiment of the invention.

Fig. 13 is a circuit diagram showing a variable gain amplifier circuit configuration as a modified example of the fifth embodiment of the invention.

Fig. 14 is a circuit diagram showing a variable gain amplifier circuit configuration according to a sixth embodiment of the invention.

Fig. 15 is a circuit diagram showing a variable gain amplifier circuit configuration as a modified example of the sixth embodiment of the invention.

Fig. 16 is a circuit diagram showing a variable gain amplifier circuit configuration as a modified example of the sixth embodiment of the invention.

Fig. 17 is a circuit diagram showing a variable gain amplifier circuit configuration as a modified example of the sixth embodiment of the invention.

Fig. 18 is a circuit diagram showing a variable gain amplifier circuit according to a seventh embodiment of the invention.

Fig. 19 is a circuit diagram showing a variable gain amplifier circuit configuration as a first modified example of the seventh embodiment of the invention.

Fig. 20 is a circuit diagram showing a variable gain amplifier circuit configuration as a second modified example of the seventh embodiment of the invention.

Fig. 21 is a circuit diagram showing a variable gain amplifier circuit configuration according to an eighth embodiment of the invention.

Fig. 22 is a circuit diagram showing a variable gain amplifier circuit configuration as a modified example of the eighth embodiment of the invention.

Fig. 23 is a circuit diagram showing a variable gain amplifier circuit according to a ninth embodiment of the invention.

Fig. 24 is a circuit diagram showing a variable gain amplifier circuit according to the ninth embodiment of the invention.

Fig. 25 is a block diagram showing a variable gain amplifier circuit configuration according to a tenth embodiment of the invention.

Fig. 26 is a graph showing the relation of the voltage gain Av to the digital signal gain_state_1 of the variable gain amplifier circuit according to the tenth embodiment of the invention.

Fig. 27 is a block diagram showing a variable gain amplifier circuit configuration according to an eleventh embodiment of the invention.

Fig. 28 is a graph showing the relation of the voltage gain Av to the digital signal gain_state_2 of the variable gain amplifier circuit according to the eleventh embodiment of the invention.

Fig. 29 is a block diagram showing a variable gain amplifier circuit configuration according to a twelfth embodiment of the invention.

Fig. 30 is a graph showing the relation of the voltage gain Av to the digital signal gain_state_3 of the variable gain amplifier circuit according to the twelfth embodiment of the invention.

Fig. 31 is a block diagram showing the configuration of a radio communication apparatus according to a thirteenth embodiment of the invention.

Fig. 32 is a circuit diagram showing a conventional variable gain amplifier circuit configuration as a first example.

Fig. 33 is a circuit diagram showing a conventional variable gain amplifier circuit configuration as a second example.

Fig. 34 is a circuit diagram showing a conventional variable gain amplifier circuit configuration as a third example.

Fig. 35 is a graph showing the relation between the suppression ratio IM3 and the collector current IO with respect to the voltage gain Av in the conventional variable gain amplifier circuit as the first example.

Fig. 36 is a graph showing the relation between the suppression ratio IM3 and the collector current IO with respect to the voltage gain Av in the conventional variable gain amplifier circuits as the second and third examples.

Description of Reference Numerals and Signs in the drawings: 11, 21 denote variable gain amplifier circuit bodies; 12, 22, decoders; 104, a transmission RF variable gain amplifier circuit; 107, a reception RF variable gain amplifier circuit; Q1 - Q6 and Qb1 - Qb6, bipolar transistors; Mn0 - Mn2, Mp0 - Mp2, Mp20 - Mp22, Mp200 and M1 - M8, MOS transistors; Re, and Re0 - Re2, emitter degeneration resistors; Rec0 - Rec2, emitter degeneration resistors in phase; Rs0 - Rs2, source degeneration resistors; Rsc0 - Rsc2, source degeneration resistors in phase; SW0, SW1 and SW2, switches; Ic10 and 10, collector currents; and gain_state_1 and gain_state_2, digital signals.

<Best Mode for Carrying Out the Invention>

A description will now be given of embodiments of the invention by reference to the drawings.

(First embodiment)

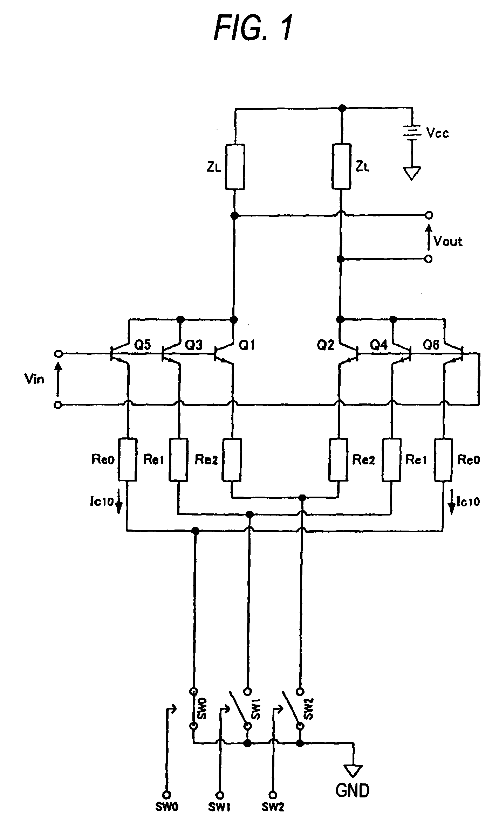

Fig. 1 is a circuit diagram showing a variable gain amplifier circuit according to a first embodiment of the invention.

The variable gain amplifier circuit according to the first embodiment of the invention is formed such that the bases of bipolar transistors Q1, Q3 and Q5 and the bases of bipolar transistors Q2, Q4 and Q6 are connected in common with each other, these bipolar transistors forming a plurality of common-emitter amplifier circuits; a switch SW2 is connected to the emitter sides of the bipolar transistors Q1 and Q2; a switch SW1 to the emitter sides of bipolar transistors Q3 and Q4; and a switch SW0 to the emitter sides of the bipolar transistors Q5 and Q6. Thus, the desired common-emitter amplifier circuit can be selected by each of the switches SW2, SW1 and SW0.

With the arrangement of Fig. 1, when any emitter side of a bipolar transistor pair is held at ground potential gnd by switching on/off the switches SW2, SW1 and SW0 by means of a control signal from the outside, the bipolar transistor pair operate as an common-emitter amplifier circuit and when the emitter side is not held at the ground potential gnd, the bipolar transistor pair do not operate as the common-emitter amplifier circuit because no collector current flows. It is thus possible to control a voltage gain by switching on/off the switches SW2, SW1 and SW0 to select the amplifier circuits different in voltage gain.

According to this embodiment of the invention, the emitter area ratio between the bipolar transistors forming the common-emitter amplifier circuit is in powers of 2 and the resistance value ratio between the emitter degeneration resistors Re0, Re1 and Re2 is inversely proportional to the emitter area ratio between the bipolar transistors. In other words, it is arranged that the relation between equations 6a and 6b below is satisfied.

$$Is5 = Is3/2 = Is1/4 \tag{6a}$$

$$Re0/4 = Re1 /2 = Re2 \tag{6b}$$

The reason for setting the emitter area ratio between the bipolar transistors in powers of 2 is that the area ratio is readily realizable with accuracy when the physical configuration of the element is taken into consideration. When a mask layout is carried out with the circuit according to this embodiment of the invention as IC or LSI, for example, two of the resistance elements or bipolar transistors having the same configuration are connected in parallel, whereby the resistance value of each resistance element can accurately be halved or the emitter area of each can accurately be doubled. Moreover, the emitter degeneration resistance ratio is so arranged as to be preferably in powers of 2. Even though the area ratio of the bipolar transistor is not set to powers of 2 but to any given ratio, the same circuit operation is made possible thereby, provided the ratio of the emitter degeneration resistance value is inversely proportional to the emitter area ratio of the bipolar transistor.

Assuming that the bias voltages of the bases of the bipolar transistors Q1 and Q2 are constant for the sake of brevity, the ratio of a collector current IO is also in powers of 2. In other words, the collector current ratio in the amplifier circuit by mean of the bipolar transistor becomes inversely proportional to the emitter degeneration resistance ratio. Further, with the state as a gain state in which only one of the switches SW0, SW1 and SW2 is held at the ground potential gnd, the gain_state is defined as being 0, 1 or 2. Although a three-bit configuration is shown in Fig. 1 by way of example with three switches provided, the basic operation remains unchanged even when the number of bits is increased or decreased.

The voltage gain Av1 of the variable gain amplifier circuit according to the first embodiment of the invention is made controllable according to the gain_state as expressed by an equation 7a below under the assumption of ideal bipolar transistors.

$$Av1 = gm1 \cdot ZL \tag{7a}$$

provided gm1, Re and IO are expressed by equations 7b, 7c and 7d below.

$$gm1 = 1/(Re + (Vt/IO) \tag{7b}$$

$$Re = Re5/(2^{gain\_state}) \tag{7c}$$

$$IO = Ic10 \cdot (2^{gain\_state}) \tag{7d}$$

wherein $2^{gain\_state}$ denotes 2 to the power of gain_state; and 1c10 denotes the collector current IO when the gain_state is 0.

Although the bias voltages of the bases of the bipolar transistors Q1 and Q2 are set constant for the sake of brevity as described above, the bias voltages of the bases are not necessarily constant in that similar gain control is made possible by devising an alternative bias circuit so that the collector current 10 is changed in a manner inversely proportional to the emitter resistant Re.

Fig. 2 is a circuit diagram showing a variable gain amplifier circuit configuration including bias circuits for exactly realizing the ratio of the collector current IO above as an application example of the first embodiment of the invention.

The variable gain amplifier circuit as the application example is provided with bias circuits respectively corresponding to a plurality of common-emitter amplifier circuits, whereby the ratio of the collector current IO becomes exactly attainable even though the collector current IO is changed by the gain_state. As seen from Eqs. 7a - 7d, the collector current decreases when the voltage gain is lowered in this variable gain amplifier circuit. On the other hand, a suppression ratio IM3 becomes equal to what results from Eq. 3 and Eq. 4 and is expressed by an equation 8 below under the assumption of ideal bipolar transistors.

$$IM3 = (3/4)\cdot|(Vt/(IO^3)\cdot(2\cdot Re - (Vt/IO))) \ /((Re + (Vt/10))^4)|\cdot(Vin^2) \qquad (8)$$

Provided the on-resistance of the switch can be disregarded, the midpoint is held at the ground potential gnd completely and ideal bipolar transistors totally coincide with Eq. 8.

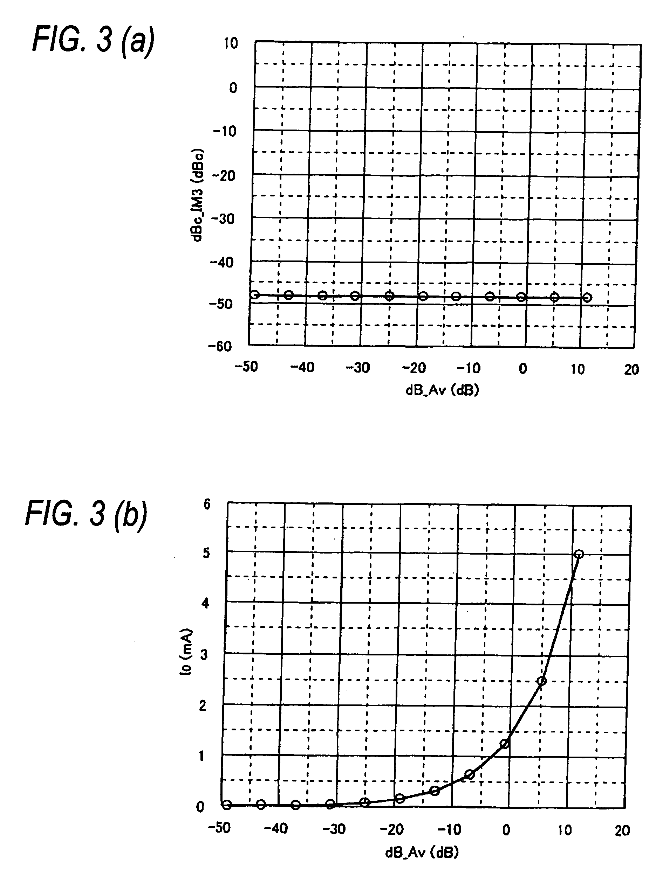

When Eqs. 7c and 7d are substituted for Eq. 8, the suppression ratio IM3 is seen to remain unchanged even though the gain_state is changed in this variable gain amplifier circuit. In other words, the suppression ratio is kept constant even though the voltage gain Av is lowered. Figs. 3(a) and (b) show the relation between the suppression ratio IM3 and the collector current 10 with respect to a voltage gain Av when the voltage gain Av is controlled by varying the gain_state calculated from the Eqs. 7a - 7d (the voltage gain being Av1 in the equations).

As described above, according to the first embodiment of the invention, the bases of the bipolar transistor pairs forming the plurality of common-emitter amplifier circuits are set for common use and the switches are provided on the respective emitter sides of the bipolar transistor pairs forming the common-emitter amplifier circuits whereby to use the switch for selecting any one of the common-emitter amplifier circuits. Thus, the current decreases when the voltage gain is lowered, so that a variable gain amplifier circuit substantially free of a deterioration in distortion characteristics can be realized.

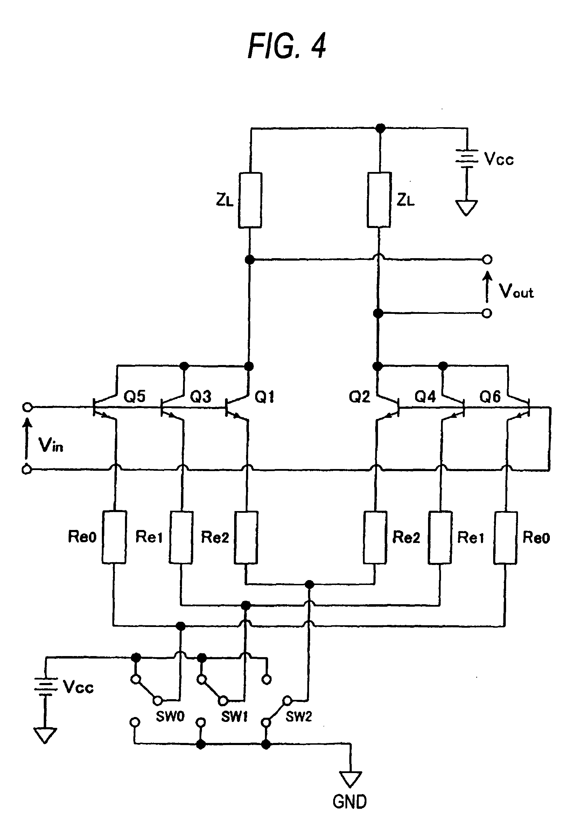

Although the emitter side of the bipolar transistor is held at the ground potential gnd by switching the switches SW2, SW1 and SW0 in the configuration of Fig. 1, other modified examples may be considered. Fig. 4 is a circuit diagram showing a variable gain amplifier circuit configuration as a modified example of the first embodiment of the invention. In this modified example, a positive power supply voltage Vcc is usable without holding the emitter side of the bipolar transistor at the ground potential gnd by switching the switches SW2, SW1 and SW0. With a circuit configuration like this, the same effect is achievable as well.

(Second embodiment)

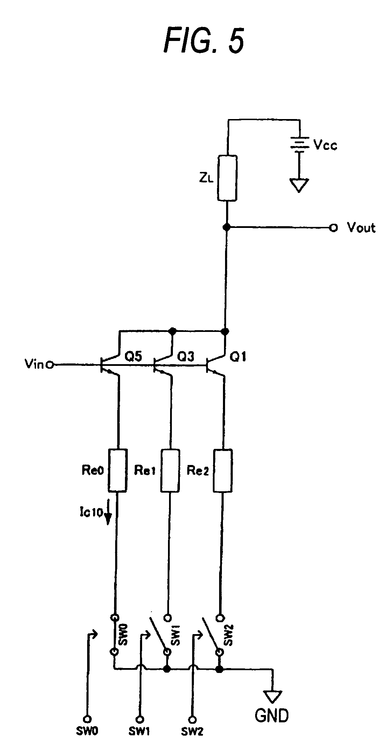

Fig. 5 is a circuit diagram showing a variable gain amplifier circuit configuration according to a second embodiment of the invention.

The variable gain amplifier circuit according to the second embodiment of the invention is such that the differential type circuit in the differential form shown in Fig. 1 according to the first embodiment of the invention is changed to a single-ended type one. This variable gain amplifier circuit is formed such that the bases of bipolar transistors Q1, Q3 and Q5 forming a plurality of common-emitter amplifier circuits are connected in common with each other and that switches SW2, SW1 and SW0 are connected to the respective emitter sides thereof.

The circuit operation is the same as what is described in the first embodiment of the invention. When the emitter side of any bipolar transistor is held at the ground potential gnd in the configuration of Fig. 5 by switching the switches SW2, SW1 and SW0, the bipolar transistor operates as an common-emitter amplifier circuit and does not operate as the amplifier circuit when the emitter side thereof is not held at the ground potential gnd because no collector current flows. Thus, the voltage gain is made controllable by switching the switches SW2, SW1 and SW0 to select any one the amplifier circuits different in the voltage gain.

According to the second embodiment of the invention, the bases of the bipolar transistor forming the plurality of common-emitter amplifier circuits are connected in common with each other and the switches are provided on the respective emitter sides of the bipolar transistor forming the common-emitter amplifier circuits whereby to use the switch for selecting any one of the common-emitter amplifier circuits. Thus, the current decreases when the voltage gain is lowered, so that a variable gain amplifier circuit substantially free of a deterioration in distortion characteristics can be realized.

(Third embodiment)

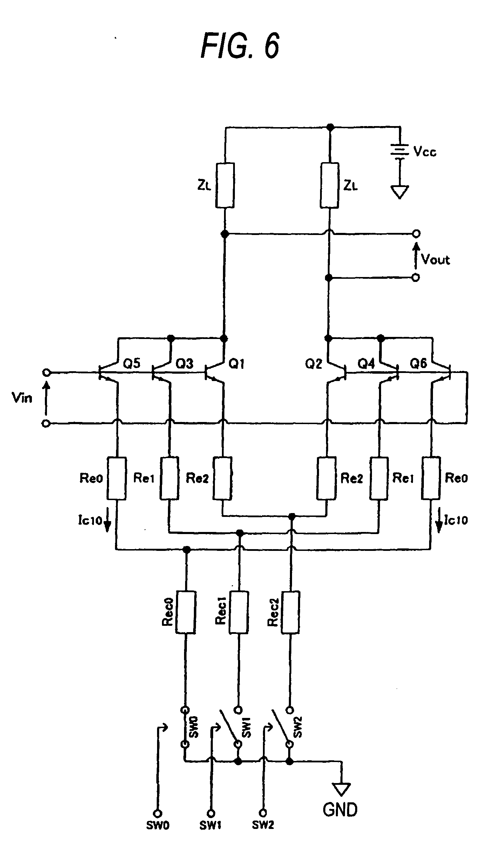

Fig. 6 is a circuit diagram showing a variable gain amplifier circuit configuration according to a third embodiment of the invention. The third embodiment of the invention refers to a partially modified example of the first embodiment of the invention above.

The difference in configuration between the third embodiment of the invention and the first embodiment thereof is that emitter degeneration resistors Rec0, Rec1 and Rec2 in phase are added to the respective bipolar transistor pairs; the rest is configured as in the first embodiment thereof. The resistance value ratio of each of the emitter degeneration resistors Rec0, Rec1 and Rec2 in phase is set inversely proportional to the emitter area ratio like the emitter degeneration resistors Re0, Re1 and Re2 so as to satisfy the relation of an equation 6c below.

$$Rec0/4 = Rec1/2 = Rec2 \qquad (6c)$$

The collector current ratio can thus be kept constant. As the voltage gain of the in-phase signal is made reducible by adding the emitter degeneration resistors Rec0, Rec1 and Rec2 in phase, the effect of reinforcing resistance to noise from the outside becomes newly achievable. The relation between the voltage gain of the differential signal, the collector current and the suppression ratio is the same as that in the first embodiment of the invention, so that the same effect still becomes achievable thereby.

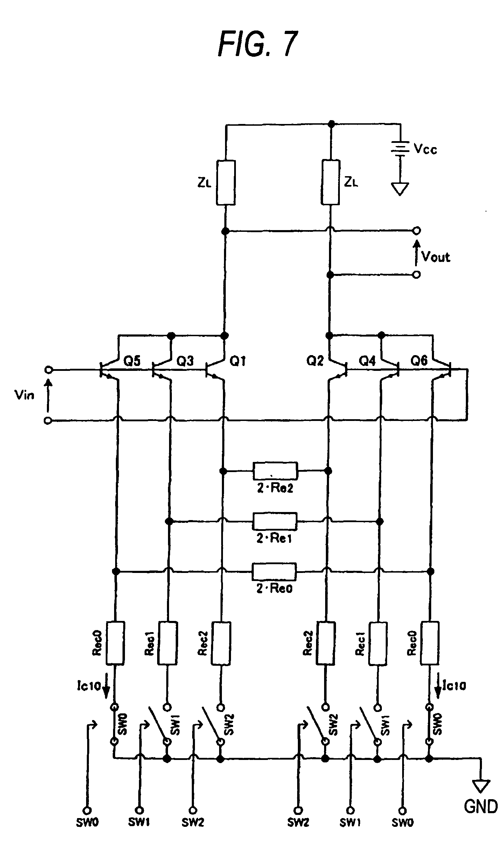

Fig. 7 is a circuit diagram showing a modified example of the third embodiment of the invention; an emitter degeneration resistor connecting configuration is different in this modified example thereof. In such a viewpoint that the emitter degeneration resistance seen from the bipolar transistors Q1 and Q2 is equivalent to the resistance value of the parallel Re2 and Rec2, this modified example is considered to be an amplifier circuit similar to the variable gain amplifier circuit of Fig. 6, so that the same effect is also made achievable by this modified example.

(Fourth embodiment)

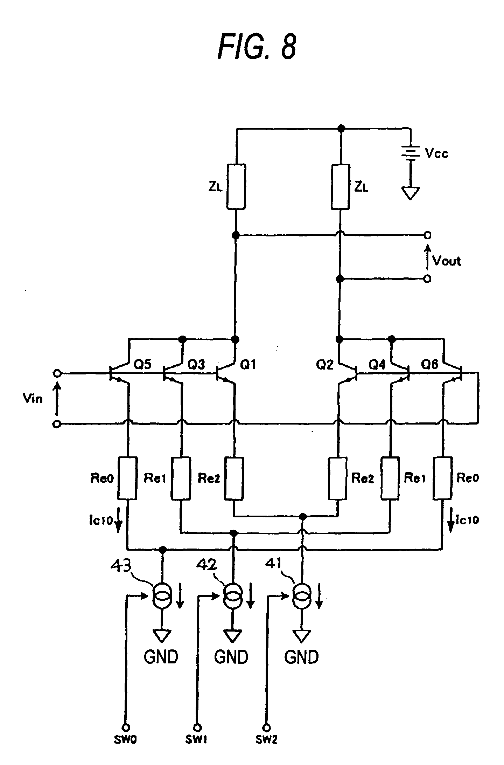

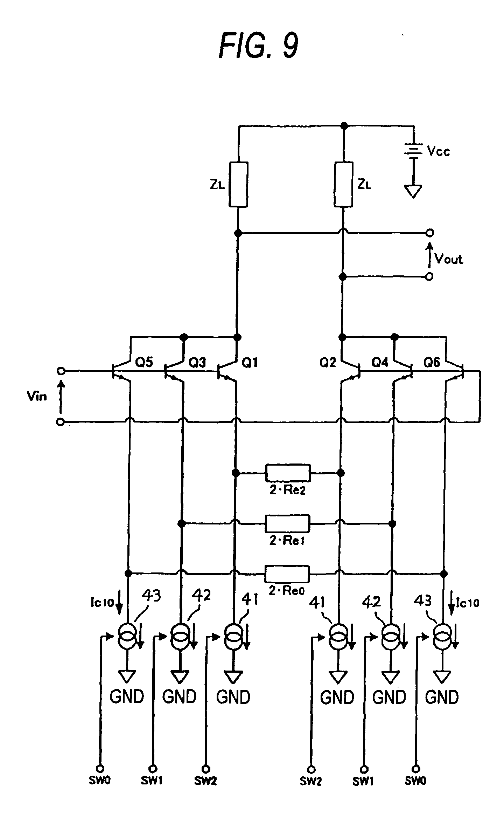

Figs. 8 and 9 are circuit diagrams showing variable gain amplifier circuit configurations according to a fourth embodiment of the invention. The fourth embodiment of the invention refers to partially modified examples of the first embodiment of the invention above.

The difference in configuration between the fourth embodiment of the invention and the first embodiment thereof is that current sources 41, 42 and 43 are used as switches; the rest is configured as in the first embodiment thereof. The examples shown in Figs. 8 and 9 are different in the arrangement for connecting the emitter degeneration resistors Re0, Re1 and Re2 and the current sources 41, 42 and 43. When the collector current ratio set at each of the current sources 41, 42 and 43 is set by Eq. 7d likewise in the variable gain amplifier circuit according to the fourth embodiment of the invention, the relation between the voltage gain, the collector current and the suppression ratio is the same as that in the first embodiment of the invention, so that the same effect becomes achievable thereby.

(Fifth embodiment)

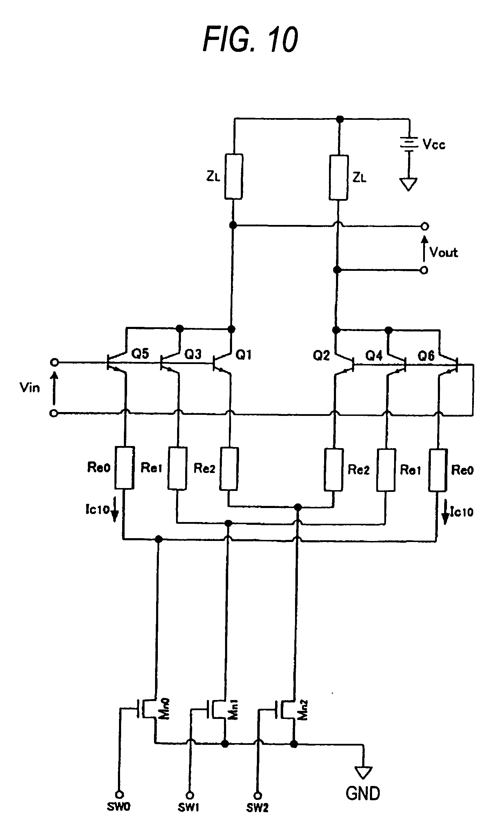

Fig. 10 is a circuit diagram showing a variable gain amplifier circuit configuration according to a fifth embodiment of the invention. The fifth embodiment of the invention refers to a partially modified example of the first embodiment of the invention above.

The difference in configuration between the fifth embodiment of the invention and the first embodiment thereof is that MOS transistors Mn0, Mn1 and Mn2 are used as switches; the rest is configured as in the first embodiment thereof. Even in this variable gain amplifier circuit configuration according to the fifth embodiment of the invention, the relation between the voltage gain, the collector current and the suppression ratio is the same as that in the first embodiment of the invention, so that the same effect becomes achievable thereby.

In case that the MOS transistors are not regarded as ideal switches, the voltage gain is made controllable more precisely by making the gate width as large as possible to make the on-resistance as small as possible or making the on-resistance ratio equal to the emitter degeneration resistance ratio.

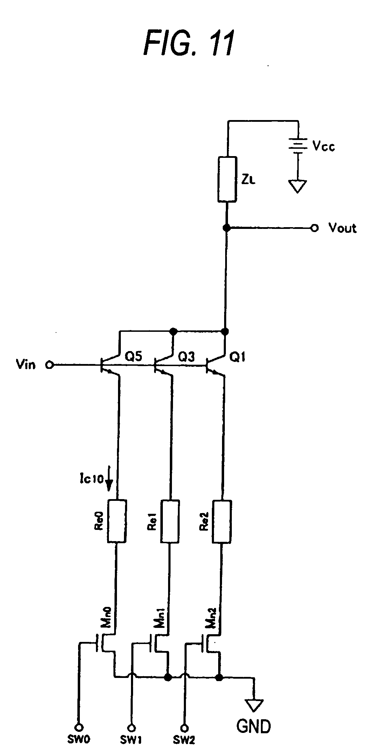

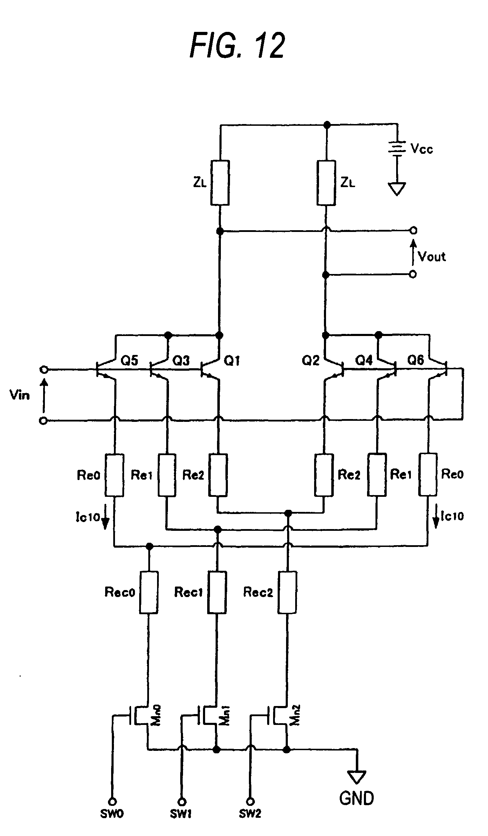

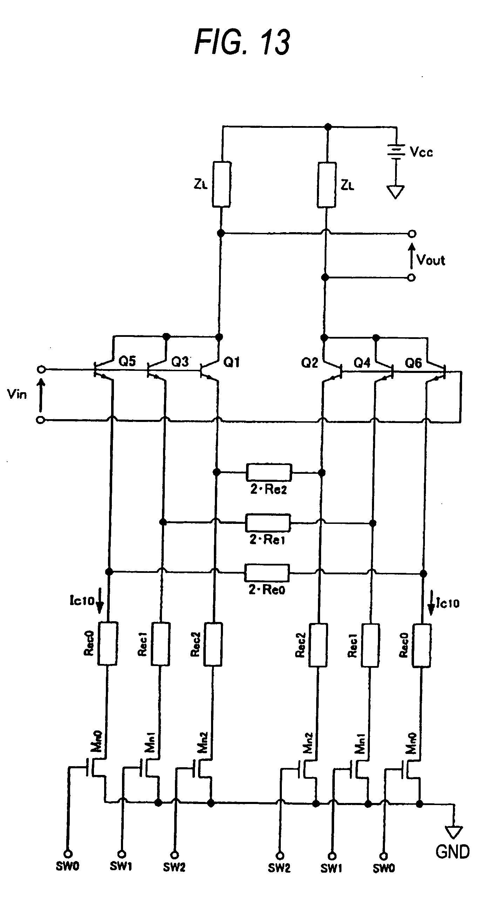

Figs. 11 - 13 are circuit diagrams showing variable gain amplifier circuit configurations as modified examples of the fifth embodiment of the invention. In these modified examples, the MOS transistors are alternatively employed as switches in a manner corresponding to the arrangements made according to the second and third embodiments of the invention as shown in Figs. 5 - 7, whereupon the same effect is also achievable by each of the modified examples above.

(Sixth embodiment)

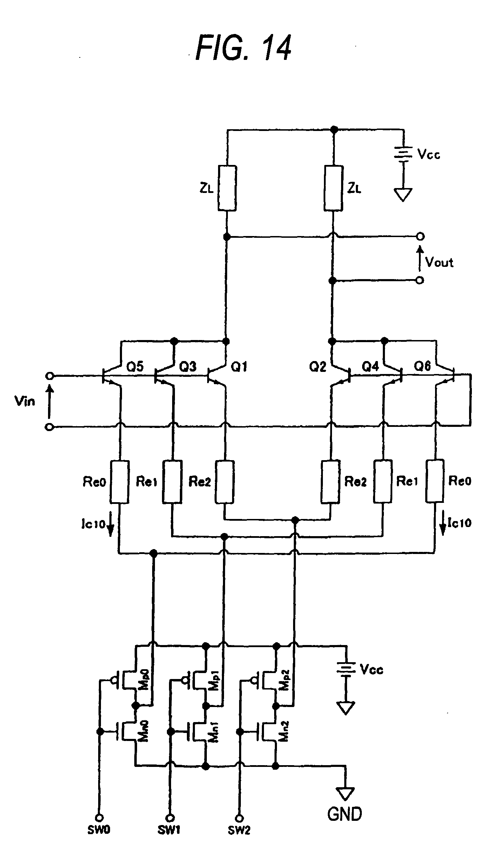

Fig. 14 is a circuit diagram showing a variable gain amplifier circuit configuration according to a sixth embodiment of the invention. The sixth embodiment of the invention refers to a partially modified example of the fifth embodiment of the invention above.

The difference in configuration between the sixth embodiment of the invention and the fifth embodiment thereof is that MOS inverters formed with MOS transistors Mn0, Mn1, Mn2, Mp0, Mp1 and Mp2 are used as switches so that when no common-emitter amplifier circuit is selected, the emitter side of the bipolar transistor is not opened but held at the potential of the positive power supply voltage; the rest is configured as in the first embodiment thereof.

When the bipolar transistor is saturated by holding the emitter side of the bipolar transistor at the potential of the positive power supply voltage, it ceases to operate as an amplifier circuit, so that the same gain control as that in the first and fifth embodiments of the invention is performable. Consequently, even in this variable gain amplifier circuit configuration according to the fifth embodiment of the invention, the relation between the voltage gain, the collector current and the suppression ratio is the same as that in the first and fifth embodiments of the invention, so that the same effect becomes achievable thereby.

In case that the MOS inverters are not regarded as ideal switches, the voltage gain is made controllable more precisely by making the gate width as large as possible to make the on-resistance as small as possible or making the on-resistance ratio equal to the emitter degeneration resistance ratio.

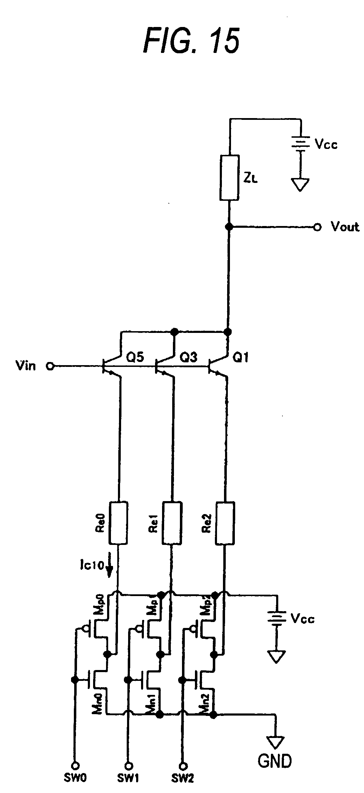

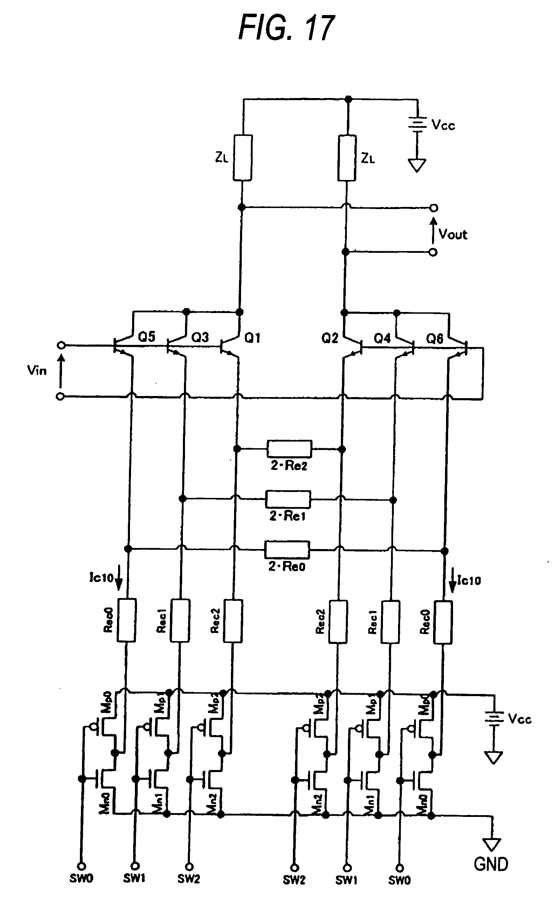

Figs. 15 - 17 are circuit diagrams showing variable gain amplifier circuit configurations as modified examples of the sixth embodiment of the invention. In these modified examples, the MOS inverters are alternatively employed as switches in a manner corresponding to the arrangements made according to the second and third embodiments of the invention as shown in Figs. 5 - 7, whereupon the same effect is also achievable by each of the modified examples above. Although the MOS inverters are employed as inverters by way of example, it is possible to have the same operation performed by using inverters different in configuration and the same effect is also achievable then.

(Seventh embodiment)

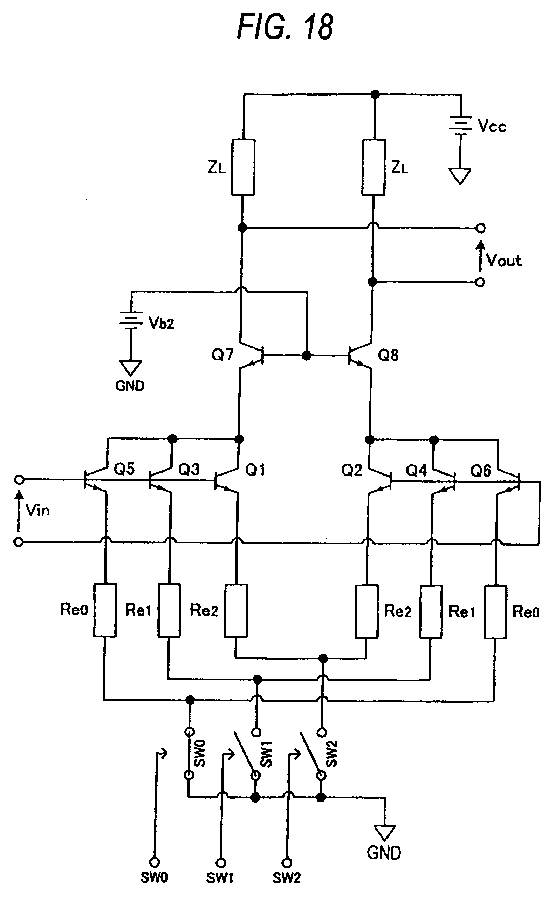

Fig. 18 is a circuit diagram showing a variable gain amplifier circuit configuration according to a seventh embodiment of the invention. The seventh embodiment of the invention refers to a partially modified example of the first embodiment of the invention above.

The difference in configuration between the seventh embodiment of the invention and the first embodiment thereof is that common-base bipolar transistors Q7 and Q8 are added with an common-emitter and common-base cascade connection; the rest is configured as in the first embodiment thereof.

A parasitic capacitance between the input Vin and the output Vout grows greater because a capacitance Cjc between the bases and collectors of the bipolar transistors Q1 and Q2 works directly according to the first embodiment of the invention, whereas the parasitic capacitance between the input Vin and the output Vout can be reduced by adding the common-base bipolar transistors Q7 and Q8.

The operation of the circuit is basically the same as that in the first embodiment of the invention and the voltage gain Av and the suppression ratio IM3 are equal to Eqs. 7a - 7d and Eq. 8 under the assumption of ideal bipolar transistors. In other words, the voltage gain can be controlled according to Eqs. 7a - 7d in an ideal case where the parasitic capacitance can be disregarded in the variable gain amplifier circuit according to any embodiment of the invention.

In case that the parasitic capacitance between the input Vin and the output Vout cannot be disregarded when a signal frequency is high or the voltage gain is lowered, on the other hand, there appears a difference in operation. In that case, as a certain constant signal leaks from the input Vin to the output Vout because of the parasitic capacitance between the input Vin and the output Vout in addition to the output in the ideal case according to the first embodiment of the invention, a deviation from the ideal gain control characteristics occurs and there develops a problem of making it impossible to lower the gain, for example. When the voltage gain is lowered or when the signal frequency is high, on the contrary, the signal leakage from the input Vin to the output Vout because of the parasitic capacitance is smaller, whereby the gain can be lowered up to a smaller voltage gain by controlling the gain. In other words, the dynamic range of the gain control can be enlarged.

The variable gain amplifier circuit is arranged with the common-emitter and common-base cascade connection according to the seventh embodiment of the invention whereby to make achievable the effect of enlarging the dynamic range of the gain control, in addition to the effect of the first embodiment thereof.

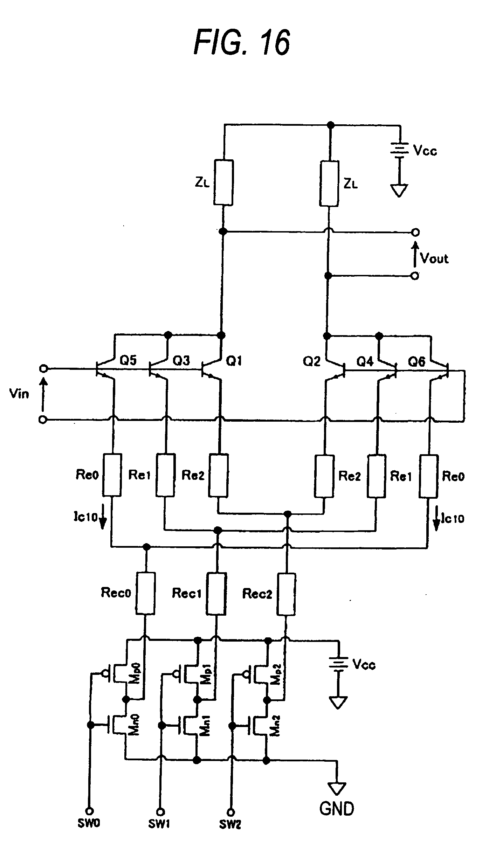

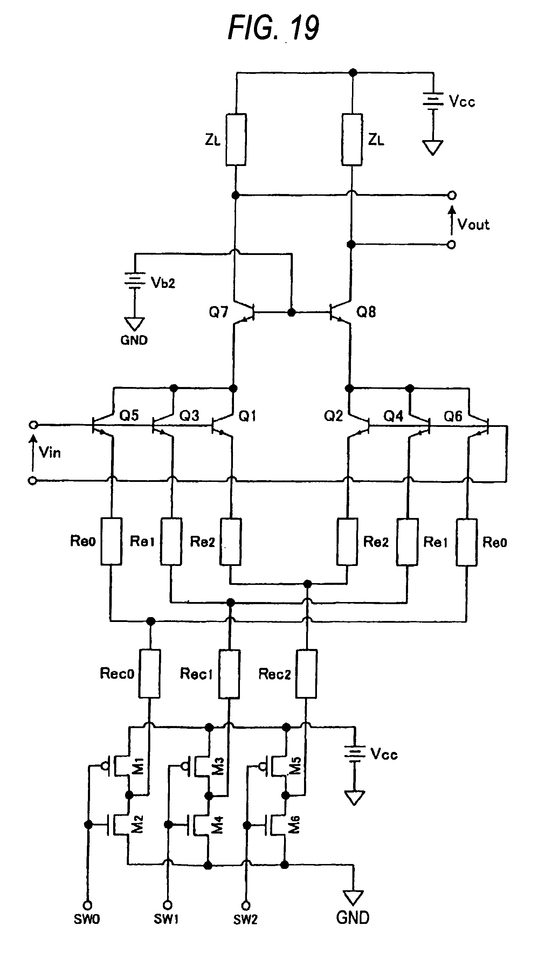

In the second - sixth embodiments of the invention as described above, the common-base bipolar transistors like Q7 and Q8 according to the seventh embodiment of the invention are added to the collector sides of the bipolar transistors forming the common-emitter amplifier circuits so that the amplifier circuit can be modified to have the common-emitter and common-base cascade connection. Then the dynamic range of the gain control can thus be enlarged. Fig. 19 is a circuit diagram showing a variable gain amplifier circuit configuration as a first modified example of the seventh embodiment of the invention. This modified example refers to the variable gain amplifier circuit having the common-emitter and common-base cascade connection in a manner corresponding to the arrangement made according to the modified example of the sixth embodiment of the invention as shown in Fig. 16, whereupon the same effect is also achievable thereby.

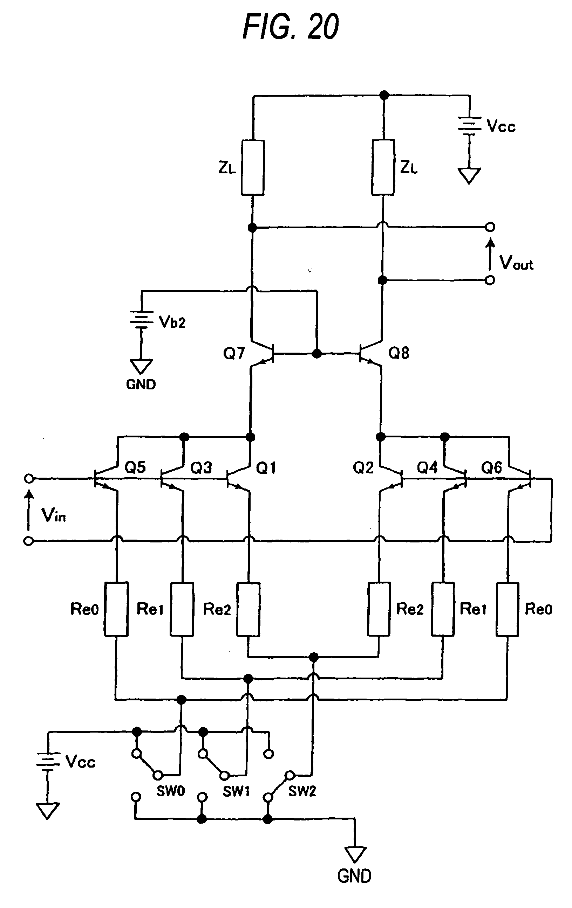

Fig. 20 is a circuit diagram showing a variable gain amplifier circuit configuration as a second modified example of the seventh embodiment of the invention. This modified example corresponds to the configuration of the modified example according to the first embodiment of the invention as shown in Fig. 4 in that the emitter sides of the bipolar transistors are held at the ground potential gnd by switching the switches SW2, SW1 and SW0 and moreover held at the positive power supply voltage Vcc when not held at the ground potential gnd. With this circuit configuration, the same effect is also achievable.

(Eighth embodiment)

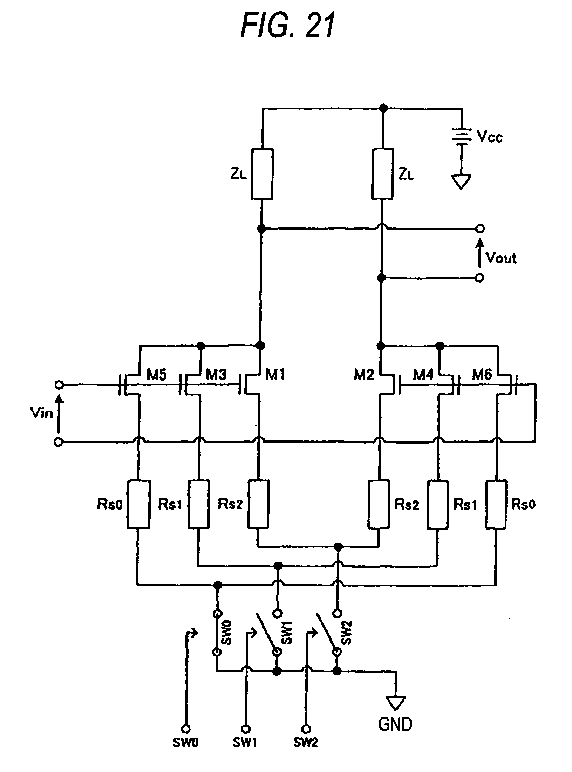

Fig. 21 is a circuit diagram showing a variable gain amplifier circuit configuration according to an eighth embodiment of the invention. The eighth embodiment of the invention refers to a partially modified example of the first embodiment of the invention above.

The difference in configuration between the eighth embodiment of the invention and the first embodiment thereof is that MOS transistors in place of bipolar transistors are employed. The variable gain amplifier circuit in this case is formed such that the gates of MOS transistors M1, M3 and M5 and the gates of MOS transistors M2, M4 and M6 are connected in common with each other, these MOS transistors forming a plurality of common-source amplifier circuits; a switch SW2 is connected to the source sides of the MOS transistors M1 and M2; a switch SW1 to the source sides of MOS transistors M3 and M4; and a switch SW0 to the source sides of the MOS transistors M5 and M6.

According to this embodiment of the invention, the ratio of each of the resistance values Rs0, Rs1 and Rs2 of the source degeneration resistors in the plurality of common-source amplifier circuits is set inversely proportional to the ratio of the gate width of the MOS transistor. Preferably, the ratio of the gate width of each MOS transistor and the ratio of the resistance value of the source degeneration resistor are in powers of 2. Moreover, the drain current ratio is set inversely proportional to the source degeneration resistance ratio in the plurality of common-source amplifier circuits. Although the basic operation is the same as that in the first embodiment of the invention, the arrangement according to the eighth embodiment thereof makes achievable the effect of operating the circuit with a lower power supply voltage, in addition to the effect of the first embodiment thereof.

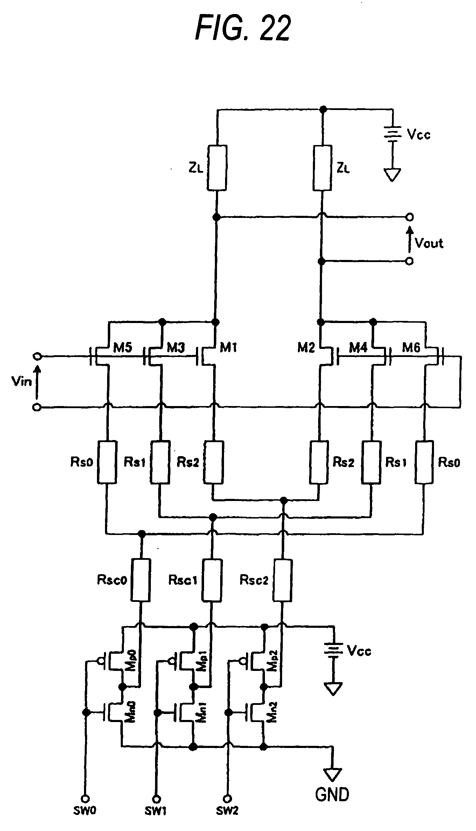

In the second - sixth embodiments of the invention as described above, MOS transistors can be substituted for the bipolar transistors forming the common-emitter amplifier circuits whereby to make achievable the effect of having the circuit operated with a lower supply voltage. Fig. 22 is a circuit diagram showing a variable gain amplifier circuit configuration as a modified example of the eighth embodiment of the invention. This modified example is so configured as to employ the MOS transistors in place of the bipolar transistors in a manner corresponding to the configuration of the modified example according to the sixth embodiment of the invention as shown in Fig. 16 and the same effect is also achievable.

Although there has been shown an example of employing the MOS transistors as field effect transistors according to this embodiment of the invention, elements for use are not limited to MOS transistors but include other field effect transistors such as GaAs MESFETs using compound semiconductors with the same effect achievable.

(Ninth embodiment)

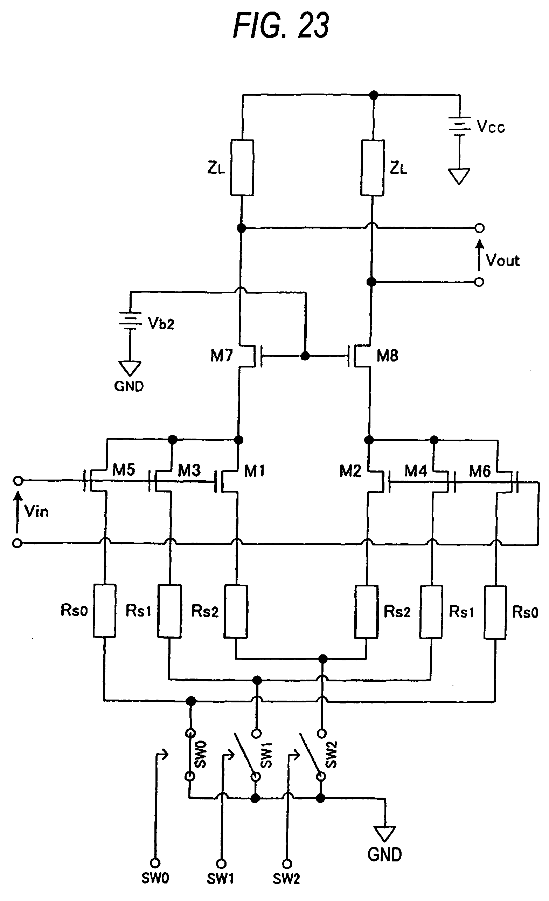

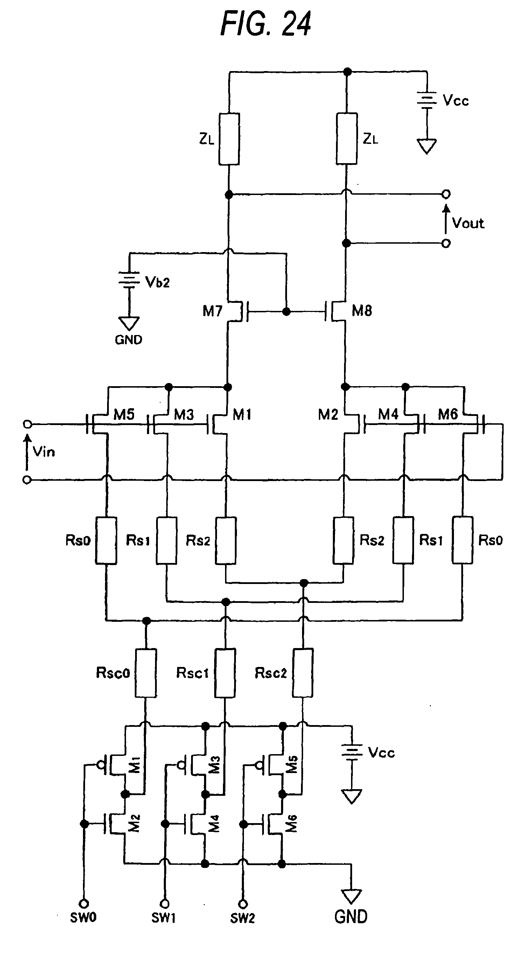

Figs. 23 and 24 are circuit diagrams showing variable gain amplifier circuits according to a ninth embodiment of the invention. The ninth embodiment of the invention refers to partially modified examples of the seventh embodiment thereof.

The difference in configuration between the ninth embodiment of the invention and the seventh embodiment thereof is that MOS transistors in place of bipolar transistors are employed. In this case, the common-gate MOS transistors like M7 and M8 are added to the configuration according to the eighth embodiment of the invention so that an amplifier circuit having a common-source and common-gate cascade connection is formed. Although the basic operation is the same as that in the seventh embodiment of the invention, the arrangement according to the ninth embodiment thereof makes achievable the effect of operating the circuit with a lower power supply voltage, in addition to the effect of the seventh embodiment thereof.

Although there has been shown an example of employing the MOS transistors as field effect transistors according to this embodiment of the invention, elements for use are not limited to MOS transistors but include other field effect transistors such as GaAs MESFETs using compound semiconductors with the same effect achievable.

(Tenth embodiment)

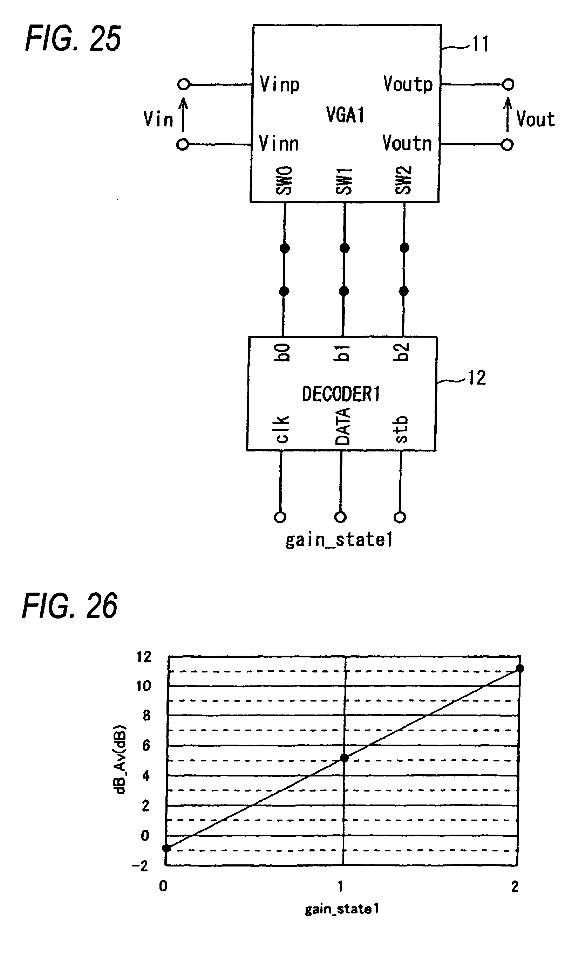

Fig. 25 is a block diagram showing a variable gain amplifier circuit configuration according to a tenth embodiment of the invention.

The variable gain amplifier circuit according to the tenth embodiment of the invention is formed with the variable gain amplifier circuit referred to in the first - ninth embodiments thereof as a variable gain amplifier circuit body (VGA1) 11, and a decoder (DECODER 1) 12 as an additional element.

The decoder 12 performs digital signal processing as shown in Table 1 whereby to feed '1' into any one of the inputs of SW2, SW1 and SW0 of the variable gain amplifier circuit body 11 in response to a digital signal gain_state_1 for setting the gain state and selects one of a plurality of amplifier circuits contained in the variable gain amplifier circuit body 11.

(Table 1)

| gain_state_1 | SW0 | SW1 | SW2 | Voltage gain Av (dB) | dB_Av (dBc) | dBc_IM3 | IO(mA) |
|---|---|---|---|---|---|---|---|
| 2 | 0 | 0 | 1 | 3.623 | 11.182 | -47.998 | 5.000 |
| 1 | 0 | 1 | 0 | 1.812 | 5.161 | -47.998 | 2.500 |
| 0 | 1 | 0 | 0 | 0.906 | -0.859 | -47.998 | 1.250 |

As a method of inputting the digital signal gain_state_1 according to the tenth embodiment of the invention, there is a method of inputting serial data by using a clock terminal clk, a data terminal data and a strobe terminal stb. However, the method of inputting the digital signal gain_state_1 is not limited to the above-mentioned but may include various modified examples to be taken into consideration.

The voltage gain at this time is controllable at about 6 dB intervals by the digital signal gain_state_1 as shown in Table 1 when the emitter degeneration resistance ratio in the plurality of amplifier circuits is in powers of 2 and when the collector current ratio in the plurality of amplifier circuits is inversely proportional to the emitter degeneration resistance ratio, for example. Fig. 26 is a graph showing the relation of a voltage gain Av (displayed in dB) to a digital signal gain_state_1 corresponding to Table 1.

According to the tenth embodiment of the invention, the voltage gain of the variable gain amplifier circuit is made controllable by using the decoder in every unit of predetermined quantities, for example, about 6 dB depending on the value of an input signal to the decoder. Although a 3-bit configuration is shown by way of example according to the tenth embodiment of the invention, the gain control range may be enlarged further by increasing the number of bits.

(Eleventh embodiment)

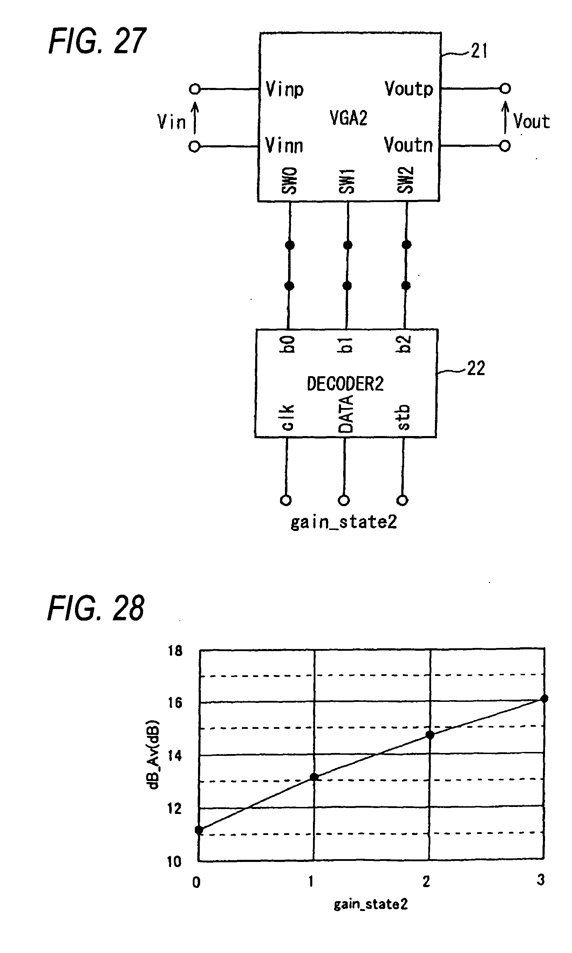

Fig. 27 is a block diagram showing a variable gain amplifier circuit configuration according to an eleventh embodiment of the invention.

The variable gain amplifier circuit according to the eleventh embodiment of the invention is formed with the variable gain amplifier circuit referred to in the first - ninth embodiments thereof as a variable gain amplifier circuit body (VGA2) 21, and a decoder circuit (DECODER 2) 22 as an additional element.

The decoder 22 always feeds '1' into SW2 corresponding to an amplifier circuit having the largest voltage gain within the variable gain amplifier circuit body 21 and performs digital signal processing as shown in Table 2 by receiving a digital signal gain_state_2 for setting the gain state whereby to feed '1' or '2' into the input of each of SW0 and SW1 of the variable gain amplifier circuit body 22 in order to select any combination of amplifier circuits out of those corresponding to SW0 and SW1.

(Table 2)

| gain_state_2 | SW0 | SW1 | SW2 | Voltage gain Av | dB_Av (dB) | dBc_IM3 (dBc) | IO(mA) |
|---|---|---|---|---|---|---|---|
| 3 | 1 | 1 | 1 | 6.341 | 16.043 | -47.998 | 8.750 |
| 2 | 0 | 1 | 1 | 5.435 | 14.704 | -47.998 | 7.500 |
| 1 | 1 | 0 | 1 | 4.529 | 13.120 | -47.998 | 6.250 |
| 0 | 0 | 0 | 1 | 3.623 | 11.182 | -47.998 | 5.000 |

As a method of inputting the digital signal gain_state_2 according to the eleventh embodiment of the invention, there is a method of inputting serial data by using a clock terminal clk, a data terminal data and a strobe terminal stb. However, the method of inputting the digital signal gain_state_2 is not limited to the above-mentioned but may include various modified examples to be taken into consideration.

At this time, about the 6 dB range is made controllable by the digital signal gain_state_2 and the voltage gain is controllable at smaller than 6 dB intervals as shown in Table 2 when the emitter degeneration resistance ratio in the plurality of amplifier circuits is in powers of 2 and when the collector current ratio in the plurality of amplifier circuits is inversely proportional to the emitter degeneration resistance ratio, for example. Fig. 28 is a graph showing the relation of a voltage gain Av (displayed in dB) to a digital signal gain_state_2 corresponding to Table 2.

According to the eleventh embodiment of the invention, the voltage gain of the variable gain amplifier circuit is made controllable by using the decoder in each smaller predetermined unit over a predetermined range of 6 dB, for example, depending on the input signal value to the decoder. Although a 3-bit configuration is shown by way of example according to the eleventh embodiment of the invention, the voltage gain control unit may be made smaller by increasing the number of bits. Moreover, the setting of gain control of the whole variable gain amplifier circuit body 21 can by changed by changing the setting of the voltage gain of the amplifier circuit into which '1' is always fed.

(Twelfth embodiment)

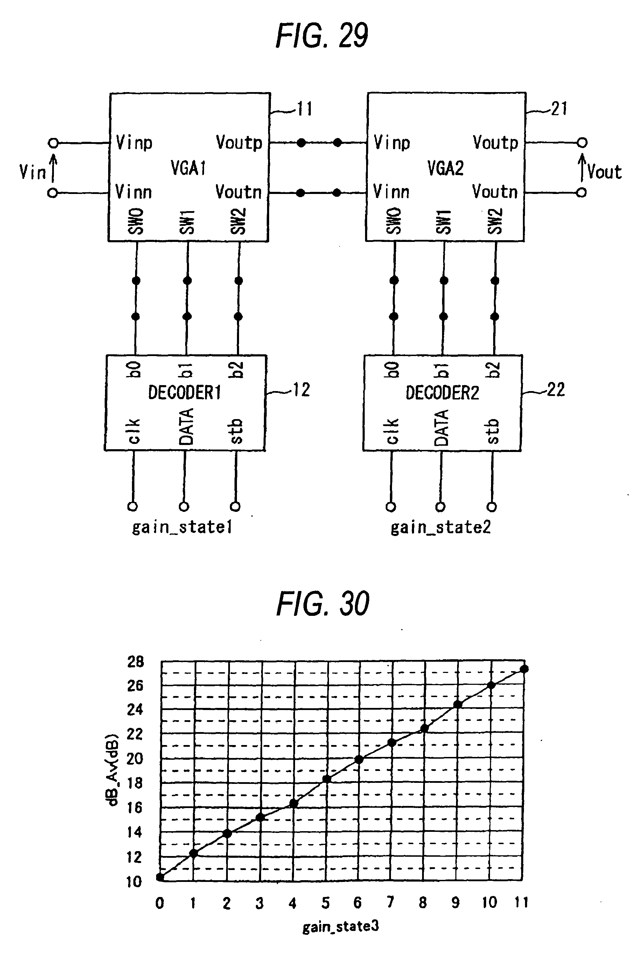

Fig. 29 is a block diagram showing a variable gain amplifier circuit configuration according to a twelfth embodiment of the invention.
The variable gain amplifier circuit according to the twelfth embodiment of the invention is formed by connecting the variable gain amplifier circuit described in the tenth embodiment thereof and the variable gain amplifier circuit described in the eleventh embodiment thereof in series.
When the digital signal gain_state_1 and the digital signal gain_state_2 in combination are fed into the decoder 12 and decoder 22 with the arrangement above, the voltage gain becomes the product (the sum displayed in dB) of the voltage gains of both variable gain amplifier circuits. The voltage gain is regarded as being controllable by the gain_state_3 when the combination of the digital signal gain_state_1 and digital signal gain_state_2 is defined as the gain_state_3.

(Table 3)

| gain_state_3 | gain_state_1 | gain_state_2 | dB_Av (dB) | dBe_IM3 (dB) | Io (mA) |
|---|---|---|---|---|---|
| 11 | 2 | 3 | 27.224 | | 13.750 |
| 10 | 2 | 2 | 25.885 | | 12.500 |
| 9 | 2 | 1 | 24.302 | | 11.250 |
| 8 | 2 | 0 | 22.364 | | 10.000 |
| 7 | 1 | 3 | 21.204 | | 11.250 |
| 6 | 1 | 2 | 19.865 | | 10.000 |
| 5 | 1 | 1 | 18.281 | | 8.750 |
| 4 | 1 | 0 | 16.343 | | 7.500 |
| 3 | 0 | 3 | 15.183 | | 10.000 |
| 2 | 0 | 2 | 13.844 | | 8.750 |
| 1 | 0 | 1 | 12.261 | | 7.500 |
| 0 | 0 | 0 | 10.322 | | 6.250 |

Fig. 30 is a graph showing the relation of the voltage gain Av (displayed in dB) to the digital signal gain_state_3 corresponding to Table 3.
According to the twelfth embodiment of the invention, the variable gain amplifier circuits using the decoders are connected in series, whereby the voltage gains of the variable gain amplifier circuits become controllable in each smaller predetermined unit over a predetermined range depending on the input signal value to the decoder. Although a 3-bit configuration is shown by way of example according to the twelfth embodiment of the invention, it is possible to not only enlarge the dynamic range of the gain control but also control the voltage gain at smaller intervals by increasing the number of bits.

(Thirteenth embodiment)

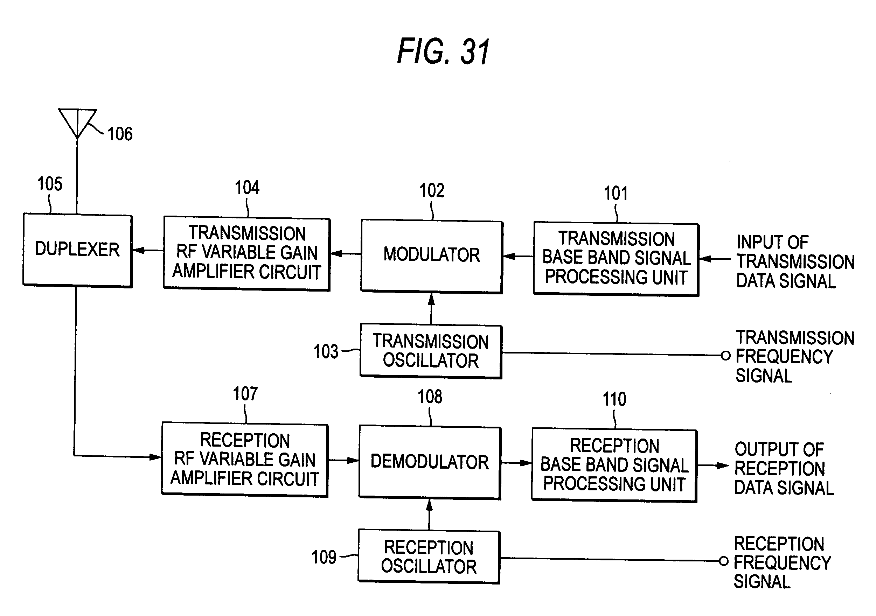

Fig. 31 is a block diagram showing the configuration of a radio communication apparatus according to a thirteenth embodiment of the invention. The thirteenth embodiment of the invention refers to an example of an application of the variable gain amplifier circuit according to tenth - twelfth embodiments thereof to the radio communication apparatus.
This radio communication apparatus is equipped with an antenna 106 and a duplexer 105; its transmission system has a transmission base band signal processing unit 101, a modulator 102, a transmission oscillator 103 and a transmission RF variable gain amplifier circuit 104; and its reception system has a reception RF variable gain amplifier circuit 107, a demodulator 108, a reception oscillator 109 and a reception base band signal processing unit 110.
The operation of the transmission system will be described first. Signal processing such as the encoding,

14

amplification, band limiting processing and the like of a base band transmitting signal is performed in the transmission base band signal processing unit 101 by means of the transmission data signal received. Frequency conversion is conducted in the modulator 102 by mixing the local oscillating signal generated by the transmission oscillator 103 and the transmitting signal to obtain a transmission RF signal. In the transmission RF variable gain amplifier circuit 104, gain control is then performed to adjust the transmission RF signal to a suitable signal level in order to avoid the saturation of the reception circuit in the partner station in case where the distance to a communicating partner is short or to lower interference with any other radio communication apparatus, for example, whereby the signal is radiated as an radio wave from the antenna 106 via the duplexer 105.

As the operation of the reception system, further, a reception RF signal received by the antenna 106 is fed into the reception RF variable gain amplifier circuit 107 via the duplexer 105. In the reception RF variable gain amplifier circuit 107, gain control is then performed to adjust the reception RF signal to a suitable signal level in order to restrain receiving signal level fluctuation due to a change in the distance to the communication partner or to avoid the saturation of the amplifier circuit because of a high-level input signal, for example. Next, frequency conversion is conducted by mixing the local oscillating signal generated by the reception oscillator 109 and a reception RF signal in the demodulator 108 to obtain a base band receiving signal. Signal processing such as the band limiting processing, amplification, decoding and the like of the receiving signal is performed in the reception base band signal processing unit 110 to regenerate the original data signal received from the communication partner, whereby the signal is outputted as a reception data signal.

According to the thirteenth embodiment of the invention, the variable gain amplifier circuit described according to the tenth - twelfth embodiments thereof is used for at least one of the transmission RF variable gain amplifier circuit 104 and reception RF variable gain amplifier circuit 107. Thus, the current decreases when the voltage gain is lowered, so that a radio communication apparatus substantially free of a deterioration in distortion characteristics can be realized.

As described above, according to this embodiment of the invention, the bases of the bipolar transistor or the sources of the MOS transistors forming the plurality of common-emitter amplifier circuits are set for common use and the switches are provided on the respective emitter sides of the bipolar transistors or the respective source sides of MOS transistors whereby to use the switch for selecting any one of the common-emitter amplifier circuits. Thus, the current decreases when the voltage gain is lowered, which results in realizing a variable gain amplifier circuit having an magnificent effect in that the amplifier circuit is substantially free of a deterioration in distortion characteristics. Moreover, it is possible to realize a radio communication apparatus substantially free of a deterioration in distortion characteristics as the current decreases when the voltage gain is lowered in radio circuits such as transmitting and receiving circuits by using the variable gain amplifier circuit according to any embodiment of the invention above in the transmission RF variable gain amplifier circuit and the reception RF variable gain amplifier circuit in the radio communication apparatus.

While the detailed and specific forms of the invention have been described, it is to be understood that various modifications will be apparent to those skilled in the art without departing from the spirit and scope of the invention.

The present application is based on Application for Japanese Patent No. 2003-006171 filed on January 14, 2003 and the contents thereof are brought herein for reference.

<Industrial Applicability>

As set forth above, it is possible to provide an excellent variable gain amplifier circuit substantially free of a deterioration in distortion characteristics represented by the suppression ratio as the current decreases when the voltage gain is lowered, and a radio communication apparatus equipped with the variable gain amplifier circuit.

**Claims**

1. A variable gain amplifier circuit comprising:

   a plurality of common-emitter amplifier circuits which are different in voltage gain and employ bipolar transistors and
   switch means for selecting the plurality of amplifier circuits, wherein:

   the bases of the bipolar transistors are connected in common with each other; and the switch means are connected to the respective emitter sides of the bipolar transistors.

2. A variable gain amplifier circuit comprising:

a plurality of amplifier circuits which are different in voltage gain and employ bipolar transistors and formed with an common-emitter and common-base cascade connection and
switch means for selecting the plurality of amplifier circuits, wherein:

the bases of the common-emitter bipolar transistors are connected in common with each other; and the switch means are connected to the respective emitter sides of the bipolar transistors.

3. The variable gain amplifier circuit as claimed in either claim 1 or claim 2, wherein a collector current ratio between the plurality of amplifier circuits is inversely proportional to an emitter degeneration resistance ratio.

4. The variable gain amplifier circuit as claimed in one of claims 1 to 3, wherein an emitter area ratio between common-emitter transistors in the plurality of amplifier circuits is inversely proportional to the emitter degeneration resistance ratio.

5. The variable gain amplifier circuit as claimed in one of claims 1 to 4, wherein the emitter area ratio between the common-emitter transistors in the plurality of amplifier circuits is in powers of 2.

6. The variable gain amplifier circuit as claimed in one of claims 1 to 5, wherein the emitter degeneration resistance ratio between the plurality of amplifier circuits is in powers of 2.

7. The variable gain amplifier circuit comprising:

a plurality of common-source amplifier circuits which are different in voltage gain and employ field effect transistors and
switch means for selecting the plurality of amplifier circuits, wherein:

the gates of the field effect transistors are connected in common with each other; and the switch means are connected to the respective source sides of the field effect transistors.

8. A variable gain amplifier circuit comprising:

a plurality of amplifier circuits which are different in voltage gain and employ bipolar transistors and formed with a common-source and common-gate cascade connection and
switch means for selecting the plurality of amplifier circuits, wherein:

the gates of the common-source field effect transistors are connected in common with each other; and the switch means are connected to the respective source sides of the field effect transistors.

9. The variable gain amplifier circuit as claimed in either claim 7 or claim 8, wherein a drain current ratio between the plurality of amplifier circuits is inversely proportional to a source degeneration resistance ratio.

10. The variable gain amplifier circuit as claimed in one of claims 7 to 9, wherein a gate width ratio between common-source transistors in the plurality of amplifier circuits is inversely proportional to the source degeneration resistance ratio.

11. The variable gain amplifier circuit as claimed in one of claims 7 to 10, wherein the gate width ratio between the common-source transistors in the plurality of amplifier circuits is in powers of 2.

12. The variable gain amplifier circuit as claimed in one of claims 7 to 11, wherein the source degeneration resistance ratio between the plurality of amplifier circuits is in powers of 2.

13. The variable gain amplifier circuit as claimed in one of claims 1 to 12, wherein the switch means is a current source.

14. The variable gain amplifier circuit as claimed in one of claims 1 to 12, wherein the switch means is a transistor.

15. The variable gain amplifier circuit as claimed in one of claims 1 to 12, wherein the switch means is an inverter.

16. The variable gain amplifier circuit as claimed in one of claims 1 to 15, having bias circuits respectively corresponding to the plurality of amplifier circuits.

17. The variable gain amplifier circuit as claimed in one of claims 1 to 16, having a decoder as decoding means for receiving and decoding a digital signal and selecting any one of the plurality of amplifier circuits by its output corresponding to the digital signal received.

18. The variable gain amplifier circuit as claimed in one of claims 1 to 16, having a decoder as decoding means for receiving and decoding a digital signal and selecting any combination of amplifier circuits by its output corresponding to the digital signal received.

19. The variable gain amplifier circuit as claimed in one of claims 1 to 16, having decoding means for receiving and decoding a digital signal, including a first decoder for selecting one of the plurality of amplifier circuits by its output corresponding to the digital signal received and a second decoder for selecting any combination of amplifier circuits by its output corresponding to the digital signal received.

20. The radio communication apparatus having the variable gain amplifier circuit as claimed in one of claims 1 to 19 as an amplifier circuit.

# FIG. 1

FIG. 2

EP 1 560 331 A1

FIG. 3 (a)

FIG. 3 (b)

EP 1 560 331 A1

# FIG. 4

# FIG. 5

# FIG. 6

# FIG. 7

# FIG. 8

# FIG. 9

# FIG. 10

## FIG. 11

## FIG. 12

# FIG. 13

# FIG. 14

# FIG. 15

## FIG. 16

## FIG. 17

## FIG. 18

## FIG. 19

# FIG. 20

## FIG. 21

## FIG. 22

## FIG. 23

# FIG. 24

FIG. 25

FIG. 26

FIG. 27

FIG. 28

## FIG. 29

## FIG. 30

## FIG. 31

106

105                104                    102                      101

DUPLEXER ←— TRANSMISSION RF VARIABLE GAIN AMPLIFIER CIRCUIT ←— MODULATOR ←— TRANSMISSION BASE BAND SIGNAL PROCESSING UNIT ←— INPUT OF TRANSMISSION DATA SIGNAL

103 —— TRANSMISSION OSCILLATOR ——o TRANSMISSION FREQUENCY SIGNAL

107                      108                      110

RECEPTION RF VARIABLE GAIN AMPLIFIER CIRCUIT → DEMODULATOR → RECEPTION BASE BAND SIGNAL PROCESSING UNIT → OUTPUT OF RECEPTION DATA SIGNAL

109 —— RECEPTION OSCILLATOR ——o RECEPTION FREQUENCY SIGNAL

EP 1 560 331 A1

# FIG. 32

# FIG. 33

# FIG. 34

FIG. 35 (a)

FIG. 35 (b)

FIG. 36 (a)

FIG. 36 (b)

**INTERNATIONAL SEARCH REPORT**

International application No.

PCT/JP2004/000181

| A. CLASSIFICATION OF SUBJECT MATTER |
|---|
| Int.Cl$^7$ H03G3/10 |

According to International Patent Classification (IPC) or to both national classification and IPC

| B. FIELDS SEARCHED |
|---|
| Minimum documentation searched (classification system followed by classification symbols) |
| Int.Cl$^7$ H03G3/10 |

Documentation searched other than minimum documentation to the extent that such documents are included in the fields searched

| | | | |
|---|---|---|---|
| Jitsuyo Shinan Koho | 1922–1996 | Toroku Jitsuyo Shinan Koho | 1994–2004 |
| Kokai Jitsuyo Shinan Koho | 1971–2004 | Jitsuyo Shinan Toroku Koho | 1996–2004 |

Electronic data base consulted during the international search (name of data base and, where practicable, search terms used)

## C. DOCUMENTS CONSIDERED TO BE RELEVANT

| Category* | Citation of document, with indication, where appropriate, of the relevant passages | Relevant to claim No. |
|---|---|---|
| X<br>Y | JP 60-212013 A (NEC Corp.),<br>24 October, 1985 (24.10.85),<br>Page 3, lower left column to lower right column; Fig. 4<br>(Family: none) | 1,2<br>3-20 |
| X<br><br>Y | JP 2002-330039 A (Sharp Corp.),<br>15 November, 2002 (15.11.02),<br>Full text; all drawings<br>& US 2002/0118065 A1 | 7,11,12-16,<br>20<br>5,6,8-10,<br>17-19 |
| X<br>Y | JP 11-177357 A (Fujitsu Ltd.),<br>02 July, 1999 (02.07.99),<br>Full text; all drawings<br>(Family: none) | 7,13-16<br>1-6,8-12,<br>17-20 |

☒ Further documents are listed in the continuation of Box C.　　☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>13 April, 2004 (13.04.04) | Date of mailing of the international search report<br>11 May, 2004 (11.05.04) |
|---|---|
| Name and mailing address of the ISA/<br>　Japanese Patent Office | Authorized officer |
| Facsimile No. | Telephone No. |

Form PCT/ISA/210 (second sheet) (January 2004)

**INTERNATIONAL SEARCH REPORT**

| | International application No. |
|---|---|
| | PCT/JP2004/000181 |

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 11-27068 A  (NEC IC Miconsystem Kabushiki Kaisha), 29 January, 1999 (29.01.99), Par. No. [0016]; Fig. 3 & US 2000/6049252 A1 | 3,4,9,10 |
| Y | JP 10-275021 A  (Sanyo Electric Co., Ltd.), 13 October, 1998 (13.10.98), Par. No. [0005]; Fig. 2 (Family: none) | 3,4,9,10 |
| Y | JP 2002-252532 A  (Sharp Corp.), 06 September, 2002 (06.09.02), Par. Nos. [0089] to [0091]; Fig. 9 (Family: none) | 17-19 |

Form PCT/ISA/210 (continuation of second sheet) (January 2004)